(19)

Europäisches Patentamt

European Patent Office

Office européen des brevets

(11) **EP 4 502 077 A1**

(12) **EUROPEAN PATENT APPLICATION**
published in accordance with Art. 153(4) EPC

(43) Date of publication:
**05.02.2025 Bulletin 2025/06**

(21) Application number: **23780465.3**

(22) Date of filing: **28.03.2023**

(51) International Patent Classification (IPC):
*C08L 101/00* (2006.01)      *C08L 101/08* (2006.01)
*C08F 2/44* (2006.01)        *C08F 2/46* (2006.01)
*C08L 63/00* (2006.01)       *G03F 7/004* (2006.01)
*G03F 7/027* (2006.01)       *C08K 3/36* (2006.01)
*H05K 3/28* (2006.01)

(52) Cooperative Patent Classification (CPC):
**C08F 2/44; C08F 2/46; C08K 3/36; C08L 63/00;
C08L 101/00; C08L 101/08; G03F 7/004;
G03F 7/027; H05K 3/28**

(86) International application number:
**PCT/JP2023/012395**

(87) International publication number:
**WO 2023/190456 (05.10.2023 Gazette 2023/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **31.03.2022   JP 2022060840**
      **31.03.2022   JP 2022060828**

(71) Applicant: **TAIYO HOLDINGS CO., LTD.**
**Saitama 355-0222 (JP)**

(72) Inventors:
• **ARAI Yasuaki**
  **Hiki-gun, Saitama 355-0215 (JP)**
• **YOSHIDA Masato**
  **Hiki-gun, Saitama 355-0215 (JP)**
• **SATO Hirohide**
  **Hiki-gun, Saitama 355-0215 (JP)**
• **SATO Kazuya**
  **Hiki-gun, Saitama 355-0215 (JP)**
• **HARIMA Eiji**
  **Hiki-gun, Saitama 355-0215 (JP)**

(74) Representative: **Hoffmann Eitle
Patent- und Rechtsanwälte PartmbB
Arabellastraße 30
81925 München (DE)**

(54) **CURED PRODUCT, PHOTOSENSITIVE RESIN COMPOSITION, DRY FILM, AND PRINTED WIRING BOARD**

(57)   Provided is a cured product that are easy to apply marking ink to the surface, have excellent adhesion with the marking ink after curing, and can form markers with excellent legibility of letters and symbols on the surface. A cured product of a curable resin composition comprising a curable resin and an inorganic filler, the inorganic filler comprising an amorphous silica, the cured product having an average linear thermal expansion coefficient of 70 to 100 ppm/°C when the temperature is changed from 0 to 180°C.

EP 4 502 077 A1

**Description**

[CROSS-REFERENCE TO RELATED APPLICATIONS]

This application is based upon and claims the benefit of priority from prior Japanese patent applications, Japanese Patent Application No. 2022-060840 (filing date: March 31, 2022) and Japanese Patent Application No. 2022-060828 (filing date: March 31, 2022), which are incorporated herein by reference in its entirety.

[TECHNICAL FIELD]

The present invention relates to a cured product and a photosensitive resin composition, more specifically, a cured products which are obtained from a curable resin composition, a photosensitive resin composition and a dry film, and a printed wiring board having a coating film formed of the cured product.

[BACKGROUND ART]

In general, in printed wiring boards used in electronic devices and the like, a solder resist layer is formed in an area on a substrate on which a circuit pattern is formed, except for connection holes, to prevent solder from adhering to unnecessary parts of a printed wiring board during steps such as solder reflow when mounting electronic components on the printed wiring board. The solder resist layer is formed by curing after applying a liquid curable resin composition to a substrate or by using a curable dry film without using a liquid curable resin composition. As a composition suitable for forming a solder resist layer, for example, Patent Document 1 discloses a curable resin composition containing a carboxyl group-containing resin having a specific acid value, an acrylic copolymer, and an epoxy resin and the like. Patent Document 2 also discloses a photosensitive film laminate having a layer containing inorganic particles as a dry film for forming a solder resist layer.

By the way, in consideration of the subsequent mounting process of electronic components, identification characters and symbols, etc. (markers) may be printed on the surface of the printed wiring board with marking ink to indicate the mounting position of the electronic components to be mounted. Marking inks are mainly of the thermosetting and UV-curing types formed by pattern printing, or of the alkaline developing type formed by exposing the ink through a negative film and removing unexposed areas with an alkaline solution. Recently, a technology called laser marking, in which a laser beam is irradiated to change the color tone of the irradiated area to display letters, symbols, etc., has also been used.

When markers are formed on a printed wiring board with a solder resist layer by marking ink as described above, depending on the application and curing conditions of the marking ink, the marking ink may be difficult to print or peel off easily due to it, resulting in reduced visibility of the markers. Especially, when the curing conditions of the marking ink were severe (e.g., when the marking ink consisted of light-curing and heat-curing resin compositions, and both light-curing and heat-curing were required to cure the ink), such tendency was more pronounced.

On the other hand, solder resist layers have various requirements such as soldering heat resistance, crack resistance, and insulation reliability, and photosensitive resin compositions that satisfy these required characteristics have been developing. For example, in Patent Document 3, it is proposed to use a combination of bisphenol-type carboxyl group-containing resin and novolac-type carboxyl group-containing resin as a photosensitive resin composition that can suppress cracking without reducing heat resistance.

In the manufacturing process of printed wiring boards, gold or tin plating is usually applied after forming a solder resist layer, for surface treatment of conductor patterns, formation of terminals for printed contacts, and bonding pad formation and the like. Electroless gold plating and electroless tin plating are now being used for these plating processes because they do not require current flow or plating leads. Therefore, improvement of resistance to plating solution is also required in photosensitive resin compositions. For example, as a photosensitive resin composition with excellent chemical resistance to plating solutions, etc., Patent Document 4 proposes to combine a bisphenol-type carboxyl group-containing resin with a carboxyl group-containing resin that is a reaction product of an unsaturated basic acid copolymerization resin and an unsaturated compound containing an alicyclic epoxy group as a photosensitive resin composition with excellent chemical resistance such as plating solution.

However, if a photosensitive resin composition as described in Patent Document 3 is used, the plating solution tends to become dirty, and in some cases, plating defects occur or the plating solution tends to be replaced more frequently when conducting electroless plating. In addition, if photosensitive resin compositions such as those described in Patent Document 4 are used, development residue is reattached to the substrate during the development process after exposure, and in some cases, plating defects may occur due to the effect of the adhered development residue.

[Prior art documents]

Patent Document

Patent Document 1: JP H10-142793 A
Patent Document 2: JP 2018-169537 A
Patent Document 3: JP 2017-529551 A
Patent Document 4: WO2003/032089 A

[SUMMARY OF INVENTION]

Accordingly, the present invention has been made in view of the above problems, and its object is to provide a cured product that is easy to apply a marking ink to the surface, has excellent adhesion with the marking ink after curing, and can form markers with excellent visibility of letters and symbols on the surface. Another object of the present invention is to provide a photosensitive resin composition that can suppress contamination of plating solution and also suppress plating defects while satisfying the properties required for solder resist, such as insulation reliability.

In response to the above-described problems, the inventors have conducted various studies and found that the printability and adhesiveness of marking ink to the surface of a cured product are affected by the condition of the curable resin composition for forming a cured product at the time of formation of the cured coating film. That is, if warpage or surface cracks occur when forming the cured coating film, a marking ink cannot be printed well afterwards, or even if it can be printed, it will peel off during the post-curing process. Furthermore, the inventors have found that the above problems can be solved if the curable resin composition contains a specific silica in order to prevent warpage and cracking and the average linear thermal expansion coefficient of the cured product cured from the curable resin composition is within a specific range.

The inventors have also found that it is possible to obtain a photosensitive resin composition that meets the characteristics required for solder resist, such as insulation reliability, while at the same time suppressing contamination of the plating solution and also suppressing plating defects by combining three specific carboxyl group-containing resins as photosensitive resin components. The present invention is based on these findings. In other words, the gist of the present invention is as follows.

[1] A cured product of a curable resin composition comprising a curable resin and an inorganic filler characterized in that the inorganic filler comprises an amorphous silica, and the cured product has an average linear thermal expansion coefficient of 70 to 100 ppm/°C when the temperature is changed from 0 to 180°C.

[2] The cured product according to [1], wherein the cured product has a glass transition point (Tg) in the range of 100 to 120°C.

[3] The cured product according to [1], wherein the cured product has an average linear thermal expansion coefficient of 70 to 85 ppm/°C when the temperature is changed from 0 to 180°C.

[4] The cured product according to [1], wherein the curable resin comprises a thermosetting resin and a photo-curable resin.

[5] The cured product according to [1], wherein the amorphous silica is contained in 2 to 30% by mass with respect to the entire curable resin composition in terms of solid content.

[6] A photosensitive resin composition comprising (A) carboxyl group-containing resin, (B) photopolymerizable monomer and (C) thermosetting component characterized in that

(A) carboxyl group-containing resin comprises:

(A1) carboxyl group-containing resin having a novolac skeleton,
(A2) carboxyl group-containing resin having a bisphenol skeleton and
(A3) carboxyl group-containing resin of an unsaturated basic acid copolymerization type,

the total amount of (A1) carboxyl group-containing resin and (A2) carboxyl group-containing resin is 60 to 80% by mass with respect to the total of (A) carboxyl group-containing resin, and

the amount of (A3) carboxyl group-containing resin is 40 to 20% by mass with respect to the total amount of (A) carboxyl group-containing resin.

[7] The photosensitive resin composition according to [6], wherein (A3) carboxyl group-containing resin is a reaction product of an unsaturated basic acid copolymerization resin and an unsaturated compound containing an alicyclic epoxy group.

[8] The photosensitive resin composition according to [6], wherein the amount of (A1) carboxyl group-containing resin is 10 to 60% by mass with respect to the total amount of (A) carboxyl group-containing resin.

[9] The photosensitive resin composition according to [6], wherein the amount of (A2) carboxyl group-containing resin is 20 to 50% by mass with respect to the total amount of (A) carboxyl group-containing resin.

[10] The photosensitive resin composition according to [6], wherein the thermosetting component comprises an epoxy resin having an isocyanuric ring.

[11] The photosensitive resin composition according to [6], further comprises (D) inorganic filler.

[12] The photosensitive resin composition according to [6], wherein (D) inorganic filler comprises a fused silica.

[13] A dry film comprising a resin layer obtained by applying and drying a photosensitive resin composition according to [6] on a first film.

[14] A cured product obtained by curing the photosensitive resin composition according to [6] or the resin layer of the dry film according to [13].

[15] The cured product according to [1] or [14], used for a solder resist.

[16] A printed wiring board comprising a substrate and the cured product according to [1] or [14] on the substrate.

The cured product according to the present invention is easy to apply marking ink to the surface thereof, has excellent adhesion to the marking ink after curing, and can also form markers with excellent visibility of letters and symbols on the surface thereof.

The photosensitive resin composition according to the present invention contains three specific carboxyl group-containing resins in specific proportions as photosensitive resin components, and thereby contamination of the plating solution can be suppressed and plating defects can also be suppressed while satisfying the characteristics required for solder resist, such as insulation reliability.

[DESCRIPTION OF EMBODIMENTS]

[Definition]

In the present invention, "average linear thermal expansion coefficient" refers to the rate of expansion of the length of the cured product, which is the test piece, per 1°C as a result of an increase in temperature.

In the present invention, "cured product" refers to the cured product obtained by curing a curable resin composition, photosensitive resin composition, or resin layer in a dry film (hereinafter referred to as "cured resin composition or the like") and it refers to the state where, upon placing a waste cloth containing isopropyl alcohol on the surface of the curable resin composition which has been subjected to curing treatment and then placing a 500g weight on the waste cloth, leaving to stand for 1 minute, the curable resin composition is not attached to the surface of the waste cloth.

[Cured Product]

The cured product according to the present invention is a cured product of a curable resin composition containing a curable resin and inorganic filler. The cured product is characterized in that the average linear thermal expansion coefficient in the length direction of the cured product (perpendicular to the thickness direction) is 70 to 100 ppm/°C when the cured product in film form with a thickness of 20 μm is changed from 0°C to 180°C in temperature. According to the present invention, if the cured product is such that the average linear thermal expansion coefficient is within the above range, it is easy to apply marking ink to the surface, has excellent adhesiveness with the marking ink after curing, and can also form markers with excellent visibility of letters and symbols on the surface. The reasons for this are not certain, but can be inferred as follows. If the cured product has an average linear thermal expansion coefficient of 70 to 100 ppm/°C when the temperature is increased from 0°C to 180°C, warpage and surface cracks are less likely to occur when the curable resin composition is cured to form the cured product, and as a result, it is considered that a highly visible marker can be formed easily by applying marking ink to the cured product surface. As a result, it is considered that the cured marker is formed with high visibility and easy to apply marking ink on the cured surface. Since the curable resin composition contains an amorphous silica, which has a lower surface smoothness than other silicas, as an inorganic filler, its anchoring effect also increases the adhesion between the cured product and marking ink, which is thought to prevent the marker from peeling off from the surface of the cured product. The average linear thermal expansion coefficient of the cured product is preferably 70 to 85 ppm/°C.

The average linear thermal expansion coefficient of the cured product can be measured by the standard method using a thermo-mechanical analyzer, but for the purpose of this invention, it shall mean the value measured as follows.

First, the curable resin composition is applied to copper foil, dried, and then heated or photo-irradiated to obtain a flat-film cured product with a thickness of 20 $\mu$m after curing.

Next, the cured product is cut into a test piece with 3 mm wide and 30 mm long, and the thermal expansion coefficient is measured in tensile mode using a thermomechanical analyzer (TMA/SS6000, Seiko Instruments Inc.). The maximum load for tension shall be 50 N/m, the span (distance between chucks) shall be 10 mm, and the temperature increase rate shall be 10°C/min. The test piece is attached to the thermo-mechanical analyzer, heated from 30°C to 200°C, and left for 10 minutes. The test piece is then cooled to -30°C at a rate of -10°C/min and measured from -30°C to 250°C at a rate of 10°C/min. Each measured value at 0°C and 180°C is read. An average linear thermal expansion coefficient ($\alpha$) is calculated using the following formula:

$$\alpha = (1/LS) * [\{L(180)-L(0)\}/(T(180)-T(0)]$$

wherein,

LS: Length (measured value) of the test piece (cured product) before measurement,
L(0): Amount of change in test piece (cured product) length at 0°C (measured value),
L(180): Amount of change in test piece (cured product) length at 180°C (measured value),
T(0):0(°C), and
T(180):180(°C).

The cured product preferably has a glass transition point (Tg) in the range of 100 to 120°C. When the Tg of the cured product is in this range, the thermal linear expansion coefficient can easily be within the desired range, resulting in a stable cured product and improved marking adhesion. The Tg of the cured product can be specified by the following contents using TMA curve when measured by a thermo-mechanical analyzer (TMA). That is, Tg of the cured product of the present invention is defined as a temperature at the point where the straight line A and B intersect (extrapolation point) when drawing a straight line A passing through two points, 0°C and 30°C, and a straight line B passing through two points, 150°C and 180°C, respectively, from the TMA curve when measured under the same conditions as the average linear thermal expansion coefficient.

The average linear thermal expansion coefficient ($\alpha$) of the cured product of the present invention can be also adjusted according to the combination ratio of curable resin and inorganic filler and the degree of this cured product by heating or light irradiation other than the above glass transition point. The glass transition point of the cured product can also be adjusted accordingly by the combination (compatibility) of the curable resin and other resins included in the curable resin composition.

<Curable Resin Composition>

The cured product according to the present invention is a cured resin composition. The cured product contains a curable resin and an inorganic filler. Needless to say, in addition to the curable resin and the inorganic filler, the cured product may also contain a curing agent and a curing accelerator that cure the curable component, as well as coloring agents and other optional additives as needed. The following is a description of each component of the cured product.

<Curable Resin>

A curable resin includes photo-curable or thermosetting resins such as acrylic resins, epoxy resins, epoxy acrylate resins, silicone resins, phenol resins, polyimide resins, polyurethane resins, melamine resins, urea resins, and other resins having photocuring or thermosetting functional groups. Although one of these resins may be used alone or in combination with two or more resins, it is preferable to use both photo-curable resins and thermosetting resins in combination in order to show excellent adhesion even under severe curing conditions such as dual curing.

A photo-curable resin of the curable resin includes a polymerizable monomers and oligomers. Such as polymerizable monomers, photo polymerizable monomers having ethylenically unsaturated double bonds can be preferably used. Examples of photopolymerizable monomers include known and customary polyester (meth)acrylates, polyether (meth)acrylates, urethane (meth)acrylates, carbonate (meth)acrylates, and epoxy (meth)acrylates. Specifically, hydroxyalkyl acrylates such as 2-hydroxyethyl acrylate and 2-hydroxypropyl acrylate; ethylene glycol, methoxytetraethylene glycol, polyethylene glycol, diacrylates of glycols such as ethylene glycol, methoxy tetraethylene glycol, polyethylene glycol, propylene glycol; acrylamides such as N,N-dimethylacrylamide, N-methylolacrylamide, N,N-dimethylaminopropylacrylamide; N aminoalkyl acrylates such as N,N-dimethylaminoethyl acrylate and N,N-dimethylaminopropyl acrylate; hexanediol, trimethylolpropane, pentaerythritol, dipentaerythritol, tris -hydroxyethyl isocyanurate, or polyhydric alcohols such as ethylene oxide adducts, propylene oxide adducts, or epsilon caprolactone adducts; phenoxyacrylates, bis(phenol A) diacrylate, and phenoxyacrylate phenol A diacrylate, and ethylene oxide or propylene oxide adducts of these phenols; glycerol diglycidyl ether, glycerol triglycidyl ether, trimethylolpropane triglycidyl ether, Polyhydric acrylates of glycidyl ethers such as glycerol diglycidyl ether, glycerol triglycidyl ether, trimethylolpropane triglycidyl ether, and triglycidyl isocyanurate; polyols including but not limited to polyether polyol, polycarbonate diol, hydroxyl-terminated polybutadiene, and polyester polyol are acrylated directly or through diisocyanates. At least one of the acrylates and melamine acrylates that are urethane acrylated, and the respective methacrylates corresponding to the aforementioned acrylates, can be selected as appropriate. Such photo polymerizable monomers can also be used as a reactive diluent.

Further, the polymerizable oligomers include unsaturated polyester oligomers and (meth)acrylate oligomers. (Meth)acrylate oligomers include epoxy (meth)acrylates such as phenol novolac epoxy (meth)acrylates, cresol novolac epoxy (meth)acrylates, and bisphenol epoxy (meth)acrylates acrylates, urethane (meth)acrylates, epoxy-urethane (meth)acrylates, polyester (meth)acrylates, polyether (meth)acrylates, polybutadiene-modified (meth)acrylates and the like.

The amount of light-curing resin in a curable resin composition is preferably 1 to 40 % by mass (solid content basis) of the carboxyl group-containing resin, and more preferably 5 to 35 % by mass (solid content basis) of the carboxyl group-containing resin, when the carboxyl group-containing resin described below is included in the curable resin composition.

Further, the curable resin composition may include a photosensitive resin that can be patterned by exposure and development. Such photosensitive resins are preferable because they can be patterned by exposure and development to form a resin cured film with the desired pattern on a substrate.

The thermosetting resins can be used as any known curable resins, for examples known compounds such as amino resins, including melamine resin, benzoguanamine resin, melamine derivatives, and benzoguanamine derivatives, isocyanate compounds, blocked isocyanate compounds, cyclocarbonate compounds, epoxy compounds, oxetane compounds, epithiophene resins, bismaleimides, and carbodiimide resins can be used. In particular, compounds that have multiple cyclic ether groups or cyclic thioether groups (hereafter abbreviated as cyclic (thio) ether groups) in their molecules can be used. These thermosetting resins can be used alone or in combination with two or more types. The inclusion of thermosetting resins can improve the strength of the cured product in subsequent processes.

The above thermosetting component having plural cyclic (thio)ether groups in the molecule include a compound having plural groups in the molecule, which groups are 3-, 4-, or 5-membered cyclic (thio)ether groups; and examples of thereof include a compound having plural epoxy groups in the molecule, that is, a polyfunctional epoxy compound; a compound having plural oxetanyl groups in the molecule, that is, a polyfunctional oxetane compound; and a compound having plural thioether groups in the molecule, that is, an episulfide resin.

Examples of such epoxy resins include bisphenol A type epoxy resin, bisphenol F type epoxy resin, hydrogenated bisphenol A type epoxy resin, brominated bisphenol A type epoxy resin, bisphenol S type epoxy resin, phenol novolac type epoxy resin, cresol novolac type epoxy resin, novolac type epoxy resin of bisphenol A, biphenyl type epoxy resin, naphthalene type epoxy resin, dicyclopentadiene type epoxy resin, and triphenylmethane type epoxy resin.

Examples of commercially available epoxy resins include: jER 828, 806, 807, YX8000, YX8034, and 834 manufactured by Mitsubishi Chemical Corporation; YD-128, YDF-170, ZX-1059, and ST-3000 manufactured by NIPPON STEEL Chemical & Material CO., LTD.; EPICLON 830, 835, 840, and 850, N-730A, and N-695 manufactured by DIC Corporation; and RE-306 manufactured by Nippon Kayaku Co., Ltd.

Examples of the polyfunctional oxetane compound include polyfunctional oxetanes such as bis[(3-methyl-3-oxetanylmethoxy)methyl]ether, bis[(3 -ethyl-3-oxetanylmethoxy)methyl]ether, 1,4-bis [(3-methyl-3-oxetanylmethoxy) methyl]benzene, 1,4-bis[(3-ethyl-3-oxetanylmethoxy)methyl]benzene, (3-methyl-3-oxetanyl)methylacrylate, (3-ethyl-3-oxetanyl)methylacrylate, (3-methyl-3-oxetanyl)methylmethacrylate, (3-ethyl-3-oxetanyl)methylmethacrylate, and an oligomer or an copolymer thereof; and, in addition to those, examples include an etherification product of oxetanealcohol with a resin having a hydroxyl group such as novolak resin, poly(p-hydroxy styrene), cardo-type bisphenols, calixarenes, calixresorcinarenes, or silsesquioxane. Besides, examples include a copolymer of an unsaturated monomer having an oxetane ring and alkyl (meth)acrylate.

Examples of the compound having plural cyclic thioether groups in the molecule include bisphenol A-type episulfide resin or the like. In addition, an episulfide resin obtained by replacing an oxygen atom of the epoxy group of novolak-type epoxy resin with a sulphur atom using the same synthesis method can be used as well.

When a carboxyl group containing resin is contained in the curable resin composition, the amount of compound with multiple cyclic (thio) ether groups in the molecule is preferably 0.8 to 2.5 moles, more preferably 1.0 to 2.0 moles of functional groups in the compound with multiple cyclic (thio) ether groups in the molecule that reacts per 1.0 moles of carboxyl groups in the resin. It is possible to prevent the remaining of carboxyl groups in the cured film, and to obtain good heat resistance, alkali resistance, electrical insulation properties and the like within the range of 0.8 mol or more of the content. It is possible to prevent the remaining of low molecular weight cyclic (thio) ether groups in the dried coating film, and to ensure good strength of the cured film and the like within the range of 2.5 mol more less of the content.

The amount of multifunctional epoxy compound added is preferably 20 to 50 parts by mass based on 100 parts by mass in terms of solid content of the containing carboxyl groups resin when the compound having multiple cyclic (thio) ether groups in its molecule is a multifunctional epoxy compound and the carboxyl group containing resin is contained in the curable resin composition.

Examples of the amino resin such as a melamine derivative or a benzoguanamine derivative include a methylol melamine compound, a methylol benzoguanamine compound, a methylol glycoluril compound, and a methylolurea compound.

As the isocyanate compound, a polyisocyanate compound can be combined. Examples of the polyisocyanate compound include: aromatic polyisocyanates such as 4,4'-diphenylmethane diisocyanate, 2,4-tolylene diisocyanate, 2,6-tolylene diisocyanate, naphthalene-1,5-diisocyanate, o-xylylene diisocyanate, m-xylylene diisocyanate, and a 2,4-tolylene dimer; aliphatic polyisocyanates such as tetramethylene diisocyanate, hexamethylene diisocyanate, methylene diisocyanate, trimethyl hexamethylene diisocyanate, 4,4-methylene bis(cyclohexyl isocyanate), and isophorone diisocyanate; aliphatic polyisocyanates such as bicycloheptane triisocyanate; and an adduct product, biuret product, and isocyanurate product of the isocyanate compound listed earlier.

As the blocked isocyanate compound, an addition reaction product of the isocyanate compound and the isocyanate blocking agent can be used. Examples of the isocyanate compound that can react with the isocyanate blocking agent include the above polyisocyanate compound. Examples of the isocyanate blocking agent include: a phenolic blocking agent; a lactam blocking agent; an active methylene-based blocking agent; an alcohol-based blocking agent; an oxime-based blocking agent; a mercaptan-based blocking agent; an acid amide-based blocking agent; an imide-based blocking agent; an amine-based blocking agent; an imidazole-based blocking agent; and an imine-based blocking agent.

In the present invention, the curable resin is preferably an alkali-soluble resin in that it can be developed when patterning. When the curable resin composition includes an alkali-soluble resin, it is preferable that it also includes a photopolymerizable monomer and a photopolymerization initiator as other components.

Alkali-soluble resins are any resins that dissolve in alkaline aqueous solutions, and well-known and conventional ones are used. The alkali-soluble resins can be used alone or in combination with two or more types. Examples of the alkali-soluble resins include water-soluble resins such as carboxyl group-containing resins and phenolic hydroxyl-containing resins. In view of developability, a carboxyl group containing resin and phenolic hydroxyl group containing resin are preferable, and a carboxyl group containing resin is more preferable. As the carboxyl group-containing resin has carboxyl groups, an alkaline development property can be imparted to the curable resin composition. In view of a perspective of photosensitivity, it is preferable to have an ethylene unsaturated double bond in the molecule in addition to the carboxyl group. However, only carboxyl group-containing resins that do not contain an ethylene unsaturated double bond may be used. An ethylene unsaturated double bond is preferably derived from acrylic acid, methacrylic acid or a derivative thereof. In a case where only a carboxyl group-containing resin having no ethylene unsaturated double bond is used, it is required to be used in conjunction with a compound having plural ethylenically unsaturated groups in the molecule described later, i.e., a photopolymerizable monomer, for the purpose of making the composition photocurable. Specific examples of the carboxyl group-containing resin include compounds as described below (may be either oligomers or polymers). It is to be noted that the term (meth)acryloyl group, when used herein, is a generic term of acrylate, methacrylate and mixtures of these; and the same is hereinafter applied to other similar expressions.

(1) A carboxyl group-containing resin obtained by copolymerization of an unsaturated carboxylic acid such as (meth) acrylic acid with an unsaturated group-containing compound such as styrene, $\alpha$-methylstyrene, lower alkyl (meth) acrylate, or isobuthylene.

(2) A carboxyl group-containing urethane resin obtained by a polyaddition reaction of a diisocyanate such as aliphatic diisocyanate, branched aliphatic diisocyanate, alicyclic diisocyanate, or aromatic diisocyanate, with a carboxyl group-containing dialcohol compound such as dimethylolpropionic acid or dimethylolbutanoic acid and a diol compound such as polycarbonate polyol, polyether polyol, polyester polyol, polyolefin polyol, acrylic polyol, bisphenol A alkylene oxide adduct diol, or a compound having a phenolic hydroxyl group and an alcoholic hydroxyl group.

(3) A carboxyl group-containing photosensitive urethane resin obtained by a polyaddition reaction of diisocyanate with (meta)acrylate of a bifunctional epoxy resin such as bisphenol A type epoxy resin, hydrogenated bisphenol A type epoxy resin, bisphenol F type epoxy resin, bisphenol S type epoxy resin, bixylenol type epoxy resin, or biphenol type epoxy resin or a partially modified acid anhydrid thereof, a carboxyl group-containing dialcohol compound, and a diol compound.

(4) A carboxyl group-containing photosensitive urethane resin obtained by adding a compound having one hydroxyl group and one or more (meth)acryloyl groups in the molecule such as hydroxyalkyl (meth)acrylate during synthesis of the resin in (2) or (3) above to be terminally (meth)acrylated.

(5) A carboxyl group-containing photosensitive urethane resin obtained by adding a compound having one isocyanate group and one or more (meth)acryloyl groups in the molecule such as equimolar reaction product of isophorone diisocyanate and pentaerythritol triacrylate during synthesis of the resin in (2) or (3) above to be terminally (meth) acrylated.

(6) A carboxyl group-containing photosensitive resin obtained by bringing a bifunctional (solid) epoxy resin or a (solid) epoxy resin with two or more functionalities into reaction with (meth)acrylic acid and adding a dibasic acid anhydride to the hydroxyl group present in a side chain.

(7) A carboxyl group-containing photosensitive resin obtained by bringing a multifunctional epoxy resin into reaction with (meth)acrylic acid and adding a dibasic acid anhydride to the generated hydroxyl group, which multifunctional epoxy resin is obtained by epoxidation of a hydroxyl group of bifunctional (solid) epoxy resin with epichlorohydrin.

(8) A carboxyl group-containing polyester resin obtained by bringing a bifunctional oxetane resin into reaction with dicarboxylic acid such as adipic acid, phthalic acid, or hexahydrophthalic acid and adding a dibasic acid anhydride such as phthalic anhydride, tetrahydrophthalic anhydride, or hexahydrophthalic anhydride to the generated primary hydroxyl group.

(9) A carboxyl group-containing photosensitive resin obtained by bringing an epoxy compound having plural epoxy groups in one molecule into reaction with a compound having at least one alcoholic hydroxyl group and one phenolic hydroxyl group in one molecule, such as p-hydroxyphenethyl alcohol, and an unsaturated group-containing monocarboxylic acid such as (meth)acrylic acid, and bringing the alcoholic hydroxyl group of the obtained reaction product into reaction with a polybasic anhydride such as maleic anhydride, tetrahydrophthalic anhydride, trimellitic anhydride, pyromellitic anhydride, or adipic acid.

(10) A carboxyl group-containing photosensitive resin obtained by bringing a compound having plural phenolic hydroxyl groups in one molecule into reaction with alkylene oxide such as ethylene oxide or propylene oxide; bringing the obtained reaction product into reaction with an unsaturated group-containing monocarboxylic acid; and bringing the obtained reaction product into reaction with a polybasic anhydride.

(11) A carboxyl group-containing photosensitive resin obtained by bringing a compound having plural phenolic hydroxyl groups in one molecule into reaction with a cyclic carbonate compound such as ethylene carbonate or propylene carbonate; bringing the obtained reaction product into reaction with an unsaturated group-containing monocarboxylic acid; and bringing the obtained reaction product into reaction with a polybasic anhydride.

(12) A carboxyl group-containing photosensitive resin obtained by further adding a compound having one epoxy group and one or more (meth)acryloyl groups in one molecule to the above resin in any of (1) to (11).

It is to be noted that the term (meth)acryloyl group, when used herein, is a generic term of acrylate, methacrylate and mixtures of these; and the same is hereinafter applied to other similar expressions.

Among the carboxyl group-containing photosensitive resin above, the photosensitive resins in (6) that use novolak epoxy resin as the epoxy resin, (7) that use bisphenol epoxy resin as the epoxy resin , and (12) are preferable to use, and in particular, it is preferable to use at least two of the aforementioned (6), (7), and (12), and it is even more preferable to use three of them.

The (6) as mentioned above is preferably contained in the entire carboxyl group-containing resin at a rate of 10 to 80% by mass, more preferably contained at a rate of 10 to 60% by mass, and even more preferably contained at a rate of 10 to 40% by mass.

The (7) as mentioned above is preferably contained in the entire carboxyl group-containing resin at a rate of 20 to 70% by mass, more preferably contained at a rate of 30 to 60% by mass, and even more preferably contained at a rate of 40 to 55% by mass.

The (12) as mentioned above is preferably contained in the entire carboxyl group-containing resin at a rate of 20 to 40% by mass, more preferably contained at a rate of 25 to 40% by mass.

The alkali-soluble resin that can be used in the present invention is not limited to those listed above. In addition, one kind of the alkali-soluble resin listed above may be used alone, or two or more kinds may be mixed and used.

The acid value of the carboxyl group-containing photosensitive resin is preferably 40 to 150 mg KOH/g. By making the acid value of the carboxyl group-containing photosensitive resin 40 mg KOH/g or more, good alkaline development is possible. In addition, by making the acid value 150 mg KOH/g or less, normal resist pattern drawing can be become easier. More preferably, the acid value is 50 to 130 mg KOH/g.

The weight average molecular weight of the carboxyl group-containing photosensitive resin varies in resin backbone and in general preferably 2,000 to 150,000. By making the weight average molecular weight 2,000 or more, tack-free performance and resolution can be improved. In addition, by making the weight average molecular weight 150,000 or less, development properties and preservation stability can be improved. More preferably, the weight average molecular weight is 5,000 to 30,000. The weight average molecular weight can be measured using gel permeation chromatography (GPC).

The amount of the carboxyl group-containing photosensitive resin combined is preferably 20 to 60% by mass in the entire composition. By making the amount 20% by mass or more, the coating film strength can be improved. In addition, by making the amount 60% by mass or less, an appropriate viscosity is attained and the printability improves. More preferably, the amount is 25 to 50% by mass.

The total amount of curable resin in a curable resin composition should be 20 to 80% by mass of the entire curable resin composition, and 30 to 70% by mass is preferable, in terms of the printability and adhesion of the marking ink

If the curable resin composition for forming the cured product contains a carboxyl group-containing resin, a photopolymerizable monomer, or an oligomer, it may also contain a photopolymerization initiator to react with exposure. Any of the known photopolymerization initiators can be used.

Specific examples of the photopolymerization initiator can include: bisacylphosphine oxides such as bis-(2,6-dichlorobenzoyl)phenylphosphine oxide, bis-(2,6-dichlorobenzoyl)-2,5-dimethylphenylphosphine oxide, bis-(2,6-dichlorobenzoyl)-4-propylphenylphosphine oxide, bis-(2,6-dichlorobenzoyl)-1-naphthylphosphine oxide, bis-(2,6-dimethoxybenzoyl)phenylphosphine oxide, bis-(2,6-dimethoxybenzoyl)-2,4,4-trimethylpentylphosphine oxide, bis-(2,6-dimethoxybenzoyl)-2,5-dimethylphenylphosphine oxide, and bis-(2,4,6-trimethylbenzoyl)-phenylphosphine oxide; monoacylphosphine oxides such as 2,6-dimethoxybenzoyl diphenylphosphine oxide, 2,6-dichlorobenzoyl diphenylphosphine oxide, 2,4,6-trimethylbenzoyl phenylphosphinic acid methyl ester, 2-methylbenzoyl diphenylphosphine oxide, pivaloyl phenylphosphinic acid isopropyl ester, and 2,4,6-trimethylbenzoyl diphenylphosphine oxide; hydroxyacetophenones such as phenyl(2,4,6-trimethylbenzoyl)ethyl phosphinate, 1-hydroxy-cyclohexyl phenyl ketone, 1-[4-(2-hydroxyethoxy)-phenyl]-2-hydroxy-2-methyl-1-propane-1-one, 2-hydroxy-1-{4-[4-(2-hydroxy-2-methyl-propionyl)-benzyl]phenyl}-2-methyl-propane-1-one, and 2-hydroxy-2-methyl-1-phenylpropane-1-one; benzoins such as benzoin, benzyl, benzoin methyl ether, benzoin ethyl ether, benzoin n-propyl ether, benzoin isopropyl ether, and benzoin n-butyl ether; benzoin alkyl ethers; benzophenones such as benzophenone, p-methylbenzophenone, Michler's ketone, methylbenzophenone, 4,4'-dichlorobenzophenone, and 4,4'-bisdiethylaminobenzophenone; acetophenones such as acetophenone, 2,2-dimethoxy-2-phenylacetophenone, 2,2-diethoxy-2-phenylacetophenone, 1,1-dichloroacetophenone, 1-hydroxycyclohexyl phenyl ketone, 2-methyl-1-[4-(methylthio)phenyl]-2-morpholino-1-propanon, 2-benzyl-2-dimethylamino-1-(4-morpholinophenyl)-butanone-1, 2-(dimethylamino)-2-[(4-methylphenyl)methyl]-1-[4-(4-morpholinyl)phenyl]-1-butanone, and N,N-dimethylaminoacetophenone; thioxanthones such as thioxanthone, 2-ethyl thioxanthone, 2-isopropyl thioxanthone, 2,4-dimethyl thioxanthone, 2,4-diethyl thioxanthone, 2-chlorothioxanthone, and 2,4-diisopropyl thioxanthone; anthraquinones such as anthraquinone, chloroanthraquinone, 2-methylanthraquinone, 2-ethylanthraquinone, 2-tert-butylanthraquinone, 1-chloroanthraquinone, 2-amylanthraquinone, and 2-aminoanthraquinone; ketals such as acetophenone dimethyl ketal and benzyl dimethyl ketal; benzoic acid esters such as ethyl-4-dimethylaminobenzoate, 2-(dimethylamino)ethyl benzoate, and p-dimethylbenzoic acid ethyl ester; oxime esters such as 1,2-octanedione,1-[4-(phenylthio)-,2-(O-benzoyloxime)], ethanone, 1-[9-ethyl-6-(2-methylbenzoyl)-9H-carbazole-3-yl]-,1-(O-acetyloxime); titanocenes such as bis(η5-2,4-cyclopentadiene-1-yl)-bis(2,6-difluoro-3-(1H-pyrrole-1-yl)phenyl)titanium, bis(cyclopentadienyl)-bis[2,6-difluoro-3-(2-(1-pyl-1-yl)ethyl)phenyl]titanium; and phenyldisulfide 2-nitrofluorene, butyroin, anisoisoethyl ether, azobisisobutyronitrile, and tetramethylthiuram disulfide.

Examples of commercially available o-aminoacetophenone-based photocuring catalysts include Omnirad 907, 369, 369E, and 379 manufactured by IGM Resins B.V. In addition, examples of commercially available acylphosphine oxide-based photocuring catalysts include Omnirad TPO H and 819 manufactured by IGM Resins B.V. Examples of commercially available oxime ester-based photocuring catalysts include: Irgacure OXE01 and OXE02 manufactured by BASF Japan Ltd.; N-1919, and Adeka Arkls NCI-831 and NCI-831E manufactured by ADEKA Corporation; and TR-PBG-304 manufactured by TRONLY.

Besides, examples include carbazole oxime ester compounds described in Japanese Patent Application Laid-Open Publication No. 2004-359639, Japanese Patent Application Laid-Open Publication No. 2005-097141, Japanese Patent Application Laid-Open Publication No. 2005-220097, Japanese Patent Application Laid-Open Publication No. 2006-160634, Japanese Patent Application Laid-Open Publication No. 2008-094770, Japanese Translated PCT Patent Application Laid-Open No. 2008-509967, Japanese Translated PCT Patent Application Laid-open No. 2009-040762, and Japanese Patent Application Laid-Open Publication No. 2011-80036.

In a case where a carboxyl group-containing resin is contained in the curable resin composition, the amount of the photoinitiator is preferably 1 to 30 parts by mass based on 100 parts by mass of the carboxyl group-containing resin in terms of solid content. In a case where the amount is 1 parts by mass or more, the photocurability of the curable resin composition becomes good, and the coating film characteristics such as chemical resistance also become good. Meanwhile, in a case where the amount is 30 parts by mass or less, effect of reducing outgassing is achieved, and in addition, light absorption on the surface of the cured film is improved, so deep curing is less likely to deteriorate. The amount of the photoinitiator is preferably 2 to 25 parts by mass.

In the present invention, a photoinitiation auxiliary agent or a photosensitizer may be used in combination with the photoinitiator. Examples of the photoinitiation auxiliary agent or the photosensitizer can include a benzoin compound, a thioxanthone compound, a ketal compound, a benzophenone compound, a tertiary amine compound, and a xanthone compound. It is particularly preferable to use a thioxanthone compound such as 2,4-dimethyl thioxanthone, 2,4-diethyl thioxanthone, 2-chlorothioxanthone, 2-isopropyl thioxanthone, or 4-isopropyl thioxanthone. By containing the thioxanthone compound, the curability in deep portions can be improved. These compounds may in some cases be used as a photoinitiator but are preferably used in conjunction with the photoinitiator. Further, one kind of the photoinitiation auxiliary agent or the photosensitizer may be used solely; or two or more kinds may be used in combination.

It is to be noted that because these photocuring catalyst, photoinitiation auxiliary agent, and photosensitizer absorb a specific wavelength, they may in some cases function as ultraviolet absorbents because of decreased sensitivity. Yet, these are not used only for the purpose of improving the sensitivity of the resin composition. Light with a specific wavelength can be absorbed as necessary such that the photoreactivity of the surface can be increased. The line shape and opening of the resist pattern can be changed to a vertical shape, a tapered shape, or a reversed tapered shape. Besides, accuracy of the width of line and a diameter of opening can be improved.

In addition, if the curable resin composition for forming the cured product includes a thermosetting resin, it may also include a thermosetting catalyst to promote curing. Examples of a thermosetting catalyst include imidazole, imidazole derivatives such as 2-methylimidazole, 2-ethylimidazole, 2-ethyl-4-methylimidazole, 2-phenylimidazole, 4-phenylimidazole, 1-cyanoethyl-2-phenylimidazole, and 1-(2-cyanoethyl)-2-ethyl-4-methylimidazole; dicyandiamide, amine compounds such as benzyldimethylamine, 4-(dimethylamino)-N,N-dimethylbenzylamine, 4-methoxy-N,N-dimethylbenzylamine, and 4-methyl-N,N-dimethylbenzylamine; hydrazine compounds such as adipic dihydrazide and sebacic dihydrazide; and phosphorus compounds such as triphenylphosphine. In addition, examples of one that is commercially available include 2MZ-A, 2MZ-OK, 2PHZ, 2P4BHZ, 2P4MHZ (all are trade names of imidazole-based compounds), which are manufactured by Shikoku Chemicals Corporation; and U-CAT, 3513N (trade names of dimethyl amine compounds), DBU, DBN, U-CAT SA 102 (all are bicyclic amidine compounds and salts thereof) which are manufactured by San-Apro Ltd. The catalyst is not in particular limited to these; and may be a thermosetting catalyst for an epoxy resin or an oxetane compound, or one that promotes a reaction of at least one kind of an epoxy group and an oxetanyl group with a carboxyl group. The catalyst may be used solely; or two or more kinds thereof may be mixed to be used.

The above-mentioned compounds are not limited to those listed, and may be used as thermosetting catalysts for epoxy resins and oxetane compounds, or as catalysts that promote the reaction between at least one of the epoxy and oxetanyl groups and the carboxyl group. They may be used alone or in a mixture of two or more types. Further, guanamine, acetoguanamine, benzoguanamine, and S-triazine derivatives such as 2,4-diamino-6-methacryloyloxyethyl-S-triazine, 2-vinyl-2,4-diamino-S-triazine, a 2-vinyl-4,6-diamino-S-triazine·isocyanuric acid adduct, and a 2,4-diamino-6-methacryloyloxyethyl-S-triazine·isocyanuric acid adduct can be used. Preferably, these compounds which function also as adhesion imparting agents are used in conjunction with the heat-curing catalyst.

One kind of thermosetting catalyst mentioned above may be solely used, or two or more kinds may be used in combination. The amount of the thermosetting catalyst is preferably 0.01 to 8 parts by mass and more preferably 0.05 to 5 parts by mass based on 100 parts by mass of the carboxyl group-containing resin when the carboxyl group-containing resin is contained in the curable resin composition.

<Inorganic Filler>

The cured product of the present invention is a cured product of a curable resin composition that contains amorphous silica as an inorganic filler. The inclusion of amorphous silica greatly improves the printability of marking ink when printing on the surface of the cured product, as well as the adhesion and visibility of the marker after printing. The reason for this is not clear, but it is thought to be as follows. Namely, since amorphous silica has a lower surface smoothness than crystalline silica, it is thought that its anchor effect improves printability and adhesion. It is noted that amorphous silica in the present invention refers to silica other than crystalline silica (including fine crystalline silica), and refers to a state of silica in which there is no long-range order like crystalline silica, but there is short-range order. From a thermodynamic perspective, it is a metastable state that is not in equilibrium. Commonly known amorphous silica can be used, and examples include silica gel and diatomaceous earth. In addition, amorphous silica can be synthetic silica as long as it is amorphous.

In terms of the application of marking ink and the adhesion of marking ink during curing, amorphous silica is preferable to have an oil absorption volume of 180 to 350 ml/100 g. Such amorphous silica is porous, and it can be assumed that the absorption of an organic solvent etc. during curing and drying results in amorphous silica and other body pigments becoming more tightly packed, thereby improving the coating properties and adhesion of the marking ink. The amount of oil absorbed should be 200 to 300 ml/100 g. In the present invention, the amount of oil absorbed is measured in accordance with "JIS K5101-13-1:2004, Pigment Testing Methods - Part 13: Oil Absorption - Section 1: Refined Linseed Oil Method".

Amorphous silica can be of a known conventional type, and can be either synthetic or natural. It may or may not have undergone surface treatment. The types of surface treatment are the same as those of the body pigments described above. Examples of products include ACEMATT 82, ACEMATT 790, ACEMATT OK 412, and ACEMATT OK 500 (all manufactured by Evonik Degussa) and the like.

The above amorphous silica may be surface-treated in order to enhance the dispersibility in the curable resin composition. Aggregation can be suppressed by using a surface-treated amorphous silica. The surface treatment method is not particularly limited, and a commonly used known method may be used. However, it is preferable to treat the surface of the amorphous silica with a surface treatment agent having a curable reactive group, for example, a coupling agent having a curable reactive group as an organic group and the like.

As the coupling agent, coupling agents such as silane-based, titanate-based, aluminate-based, and zircoaluminate-based coupling agents can be used. Of these, a silane-based coupling agent is preferable. Examples of such a silane-based coupling agent can include vinyl trimethoxysilane, vinyl triethoxysilane, N-(2-aminomethyl)-3-aminopropylmethyl dimethoxysilane, N-(2-aminoethyl)-3-aminopropyl trimethoxysilane, 3-aminopropyl triethoxysilane, 3-anilinopropyl trimethoxysilane, 3-glycydoxypropyl trimethoxysilane, 3-glycydoxypropylmethyl dimethoxysilane, 2-(3,4-epoxycyclohexyl)ethyl trimethoxysilane, 3-methacryloxypropyl trimethoxysilane, and 3-mercaptopropyl trimethoxysilane. These can be used solely or in combination. It is preferable that these silane-based coupling agents are previously immobilized on the surface of the filler by adsorption or reaction.

The average particle diameter (D50) of amorphous silica can be preferably used in the range of 0.1 to 10 μm, and more preferably in the range of 1 to 5 μm. The average particle size refers to the particle size at 50% cumulative volume obtained using laser diffraction particle size distribution measurement. The average particle size of amorphous silica refers to the value measured as described above for the silica before preparing (pre-mixing and kneading) the curable resin composition.

The amount of the amorphous silica in a curable resin composition is preferably 2 to 30% by mass of the entire curable resin composition in terms of solid content, and more preferably 5 to 20% by mass in view of the perspective of the printability and adhesion of the marking ink.

In addition to the amorphous silica mentioned above, other inorganic fillers can be added to the curable resin compositions as necessary to increase the physical strength of the cured product, etc. Inorganic fillers that are already known can be used, and in particular, talc, mica, aluminum oxide, calcium oxide, magnesium oxide, zinc oxide, calcium carbonate, magnesium carbonate, fly ash, dehydrated sludge, kaolin, clay, calcium hydroxide, aluminum hydroxide, magnesium hydroxide , hydrotalcite, aluminum silicate, magnesium silicate, calcium silicate, wollastonite, potassium titanate, magnesium sulfate, calcium sulfate, magnesium phosphate, sepiolite, zonolite, boron nitride, aluminum borate, silica balloon, glass flakes, glass balloons, iron and steel slag, copper, iron, iron oxide, sendust, alnico magnets, magnetic powders such as various ferrites, cement, glass powder, Neuburg clay, antimony trioxide, magnesium oxy-sulfate, hydrated aluminum, hydrated gypsum, alum and barium sulfate, etc. Other inorganic fillers may be used alone or in combination.

From the perspective of dispersibility, etc., the average particle diameter (D50) of the inorganic fillers mentioned above should be 0.1 to 200 μm, and 1 to 10 μm is even more preferable. Also, as with amorphous silica, they may be surface-treated from the perspective of dispersibility.

The total amount of inorganic filler combined with amorphous silica is preferably 20 to 70% by mass based on the entire curable resin composition in terms of the solid content, and more preferably 40 to 60% by mass. Such amount improves the prevention of adhesion loss of the curable resin composition and the resistance to cold and heat cycles, and as a result, the adhesion to the marking ink can be further improved.

<Other Components>

In addition to the above-mentioned components, the resin composition of the present invention may also contain, as necessary, at least one of the following: colorants; elastomers; mercapto compounds; urethane catalysts; thixotropes; adhesion promoters; block copolymers; chain transfer agents; polymerization inhibitors; copper poisoning inhibitors; antioxidants; rust inhibitors; organic thickeners such as bentonite and montmorillonite; defoaming agents such as silicone-based, fluorine-based, polymer-based; leveling agents; flame retardants such as phosphine acid salts, phosphate ester derivatives, and phosphazene compounds etc. These can be components that are known in the field of electronic materials.

The curable resin composition may contain an organic solvent from the viewpoint of the ease of preparation and coating property when forming the curable resin layer. As the organic solvent, commonly-used known organic solvents can be used, which include: ketones such as methyl ethyl ketone and cyclohexanone; aromatic hydrocarbons such as toluene, xylene, and tetramethylbenzene; glycol ethers such as cellosolve, methyl cellosolve, butyl cellosolve, carbitol, methyl carbitol, butyl carbitol, propylene glycol monomethyl ether, dipropylene glycol monomethyl ether, dipropylene glycol diethyl ether, diethylene glycol monomethyl ether acetate, and tripropylene glycol monomethyl ether; esters such as ethyl acetate, butyl acetate, butyl lactate, cellosolve acetate, butyl cellosolve acetate, carbitol acetate, butyl carbitol acetate, propylene glycol monomethyl ether acetate, dipropylene glycol monomethyl ether acetate, and propylene carbonate; aliphatic hydrocarbons such as octane and decane; and petroleum solvents such as petroleum ether, petroleum naphtha, and solvent naphtha. One kind of organic solvent can be used solely; or two or more kinds can be used in combination.

The amount of the organic solvent combined in the curable resin composition can be changed as appropriate depending on the material constituting the curable resin composition. In a case where the carboxyl group-containing resin is contained in the curable resin composition, the amount of the organic solvent may be, for example, 20 to 300 parts by mass based on 100 pars by mass of the carboxyl group-containing resin in terms of a solid content.

The curable resin composition may be used as a dry film or as a liquid. When used as a liquid, it may be a single-component liquid or a two-component liquid or more.

[Photosensitive Resin Composition]

The photosensitive resin composition of the present invention includes (A) a carboxyl group-containing resin, (B) a photopolymerizable monomer, and (C) a thermosetting component as essential components. The following describes each component that makes up the photosensitive resin composition of the present invention.

<(A) Carboxyl Group-Containing Resin >

The photosensitive resin composition of the present invention includes three types of carboxyl group-containing resins in specific proportions: (A1) a carboxyl group-containing resin with a novolak structure, (A2) a carboxyl group-containing resin with a bisphenol structure, and (A3) a carboxyl group-containing resin of the unsaturated base acid copolymer type. In the present invention, by including the above-mentioned three specific photosensitive resins in specific proportions as carboxyl group-containing resins, it is possible to create a photosensitive resin composition that satisfies the characteristics required of solder resist, such as heat resistance and insulation reliability, while also inhibiting contamination of the plating solution and inhibiting plating defects. The reason for this is not clear, but it can be inferred as follows.

As described in the above-mentioned patent document 4, when a carboxyl group-containing resin with a bisphenol structure and a carboxyl group-containing resin of the unsaturated base acid copolymer type are used together as photosensitive resins, the insulation reliability and heat resistance such as PCBT is excellent due to high hydrophobicity and also high molecular weight of the resins. However, the copolymer resin components of the uncured resin dissolved in the developing solution precipitate in the water tank during the cleaning process after developing, and re-adhere to the conductor (copper) of the substrate. This adhesion is thought to be the cause of plating defects in subsequent plating processes. On the other hand, when a photosensitive resin with excellent heat resistance and crack resistance (a resin containing a carboxyl group with a bisphenol or novolak structure) is used, as described in Patent Document 3, there is almost no precipitation of the above-mentioned development. Although there is almost no precipitation of the above-mentioned developing residue in the water tank, the uncured resin components and unreacted photopolymerizable monomers contained in the cured film of the photosensitive resin composition dissolve into the electroless plating bath and contaminate the plating bath. Therefore, by using the three types of carboxyl group -containing resins mentioned above in specific proportions together, it is possible to achieve a high-level balance between the hydrophobicity of the photosensitive resin as a whole (inhibiting precipitation in the water tank) and the inhibition of elution into the plating bath , and as a result, it is thought that it can suppress both the occurrence of plating defects and the contamination of plating solutions while also meeting the characteristics required of solder resist, such as heat resistance and insulation reliability.

Examples of (A1) carboxyl group-containing resins with a novolak structure include a carboxyl group-containing photosensitive resin (A1a) which is obtained by reacting a multifunctional epoxy resin such as phenol novolak epoxy resins, cresol novolak epoxy resins, bisphenol A cresol novolak epoxy resins, and dicyclopentadiene cresol novolak epoxy resins with (meth)acrylic acid, and then adding a dibasic acid anhydride such as phthalic anhydride, tetrahydrophthalic anhydride, or hexahydrophthalic anhydride to the hydroxyl group present in the side chain; a carboxyl group-containing photosensitive resin (A1b) which is obtained by reacting (meth)acrylic acid with a multifunctional epoxy resin further epoxidizing hydroxyl groups of the above multifunctional epoxy resin with epichlorohydrin; and a carboxyl group-containing photosensitive resin (A1c) which is obtained by adding cyclic ethers such as ethylene oxide or cyclic carbonates such as propylene carbonate to multifunctional phenolic compounds such as novolak resin, partially esterifying the resulting hydroxyl groups with (meth)acrylic acid, and then reacting the remaining hydroxyl groups with polybasic acid anhydride; and carboxyl group-containing photosensitive resins made by adding compounds such as glycidyl (meth) acrylate and α-methyl glycidyl (meth)acrylate, which have one epoxy group and one or more (meth)acryloyl groups in their molecules, to any of the above resins A1a to A1c. In the present invention, the cresol novolac-type carboxyl group-containing resin is preferable because it has better solder heat resistance than phenol novolac-type carboxyl group-containing resin. In the present application, the term "(meth)acrylate" is used as a generic term for acrylate, methacrylate and mixtures of these, and the same applies to other similar expressions. In addition, the term "(meth)acryloyl group" is used as a generic term for acryloyl group, methacryloyl group and mixtures of these, and the same applies to other similar expressions.

Examples of (A2) carboxyl group-containing resins with a bisphenol structure include a carboxyl group-containing photosensitive resin (A2a) which is obtained by reacting bifunctional epoxy resins such as bisphenol A epoxy resin, hydrogenated bisphenol A epoxy resin, bisphenol F epoxy resin, bisphenol S epoxy resin, etc. with (meth) acrylic acid, and then the resulting hydroxyl groups were reacted with polybasic acid anhydride; a photosensitive resin containing carboxyl groups (A2b) which is obtained by reacting (meth)acrylic acid with a multifunctional epoxy resin further epoxidizing hydroxyl groups of the above bifunctional epoxy resin with epichlorohydrin; and carboxyl group-containing photosensitive resins made by ng compounds such as glycidyl (meth) acrylate and α-methyl glycidyl (meth) acrylate, which have one epoxy group and one or more (meth) acryloyl groups in their molecules.

The carboxyl group-containing resins (A1) and (A2) described above have many free carboxyl groups in the side chains of the backbone polymer, which makes it possible to develop them using an alkaline aqueous solution. The acid value of these carboxyl group-containing resins (A1) and (A2) is preferably 40 to 200 mg KOH/g. When the acid value of the carboxyl group-containing resins A1 and A2 is 40 to 200 mgKOH/g, alkaline development becomes easier, the dissolution of the exposed areas by the developing solution is suppressed, and it becomes easier to draw fine resist patterns. More preferably, the acid value is 45 to 120 mgKOH/g.

The weight average molecular weight of the carboxyl group-containing resins described in (A1) and (A2) above will vary depending on the resin structure, however, in view of the perspective of the moisture resistance (solubility in water) of the coating film after exposure, resolution, and developability and the like, it is generally preferable to be between 2,000 and 150,000, and more preferably between 5,000 and 100,000. The weight average molecular weight refers to the standard polystyrene equivalent value measured using the gel permeation chromatography (GPC) method.

Next, (A3) unsaturated base acid copolymerization type carboxyl group-containing resin is explained below. (A3) carboxyl group-containing resin is obtained by copolymerizing (meth)acrylic acid ester with a compound that has one unsaturated group and at least one carboxyl group per molecule. Examples of a (meth)acrylic acid ester include alkyl (meth)acrylic acid esters such as methyl (meth)acrylate, ethyl (meth)acrylate, propyl (meth)acrylate, butyl (meth)acrylate, pentyl (meth)acrylate, and hexyl (meth)acrylate, as well as 2-hydroxyethyl (meth)acrylates, hydroxyl-containing (meth) acrylic acid esters such as hydroxypropyl (meth)acrylate, hydroxybutyl (meth)acrylate, and caprolactone-modified 2-hydroxyethyl (meth)acrylate, methoxy-diethylene glycol (meth)acrylate, ethoxy-diethylene glycol (meth)acrylate, isooctyl oxy-diethylene glycol (meth)acrylate, methoxy-triethylene glycol (meth)acrylate, and glycol-modified (meth)acrylates such as ethoxydiglycol (meth)acrylate, isooctyl oxy-diglycol (meth)acrylate, methoxytriethy-glycol (meth)acrylate, and methoxypolyethylene glycol (meth)acrylate. They can be used alone or mixed with two or more types.

In addition, examples of compounds having one unsaturated group and at least one carboxyl group per molecule include acrylic acid, methacrylic acid, and modified unsaturated monocarboxylic acids in which the chain between the unsaturated group and the carboxylic acid has been extended, such as β-carboxyethyl (meth)acrylate, 2-acryloyloxy ethyl succinate, 2-acryloyloxyethyl hexahydrophthalate, unsaturated monocarboxylic acids with ester bonds due to lactone modification, etc., unsaturated monocarboxylic acids with ether bonds, and those containing two or more carboxyl groups, such as maleic acid, in the molecule. They can be used alone or in a mixture of two or more types.

In the present invention, as (A3) unsaturated base acid copolymer-type carboxyl group-containing resin, a resin in which an unsaturated group is introduced into the resin by reacting a part of the acid group of the above-mentioned unsaturated base acid copolymer resin (i.e., a copolymer resin obtained by copolymerizing (meth)acrylic acid ester with a compound that has one unsaturated group and at least one carboxyl group per molecule) with the epoxy group of an alicyclic epoxy group-containing unsaturated compound, can be used. The unsaturated base acid copolymerization type carboxyl group-containing resin can be used in combination with the carboxyl group-containing resins (A1) and (A2) mentioned above in specific proportions to further improve the PCBT properties.

The alicyclic epoxy group-containing unsaturated compounds, which is reacting with some of the acid groups of the unsaturated base acid copolymer resin mentioned above, is preferably a compound having one radical polymerizable unsaturated group and an alicyclic epoxy group in a single molecule, such as those that have an alicyclic epoxy group and an acrylic group at the same time, are preferable. Examples of the compound include 3,4-epoxycyclohexylmethyl acrylate, 3,4-epoxycyclohexylethyl acrylate, 3,4-epoxycyclohexylbutyl acrylate, etc. can be used. These can be used alone or in a mixture of two or more types.

In addition to the above-mentioned compounds that contain both alicyclic epoxy and acrylic groups, it is also possible to use unsaturated compounds containing aliphatic epoxy groups, such as glycidyl (meth) acrylate, β-methyl glycidyl (meth) acrylate, and allyl glycidyl ether, in combination.

The weight average molecular weight of the carboxyl group-containing resin in (A3) above generally is preferably between 3,000 and 100,000, and more preferably between 5,000 and 50,000, in view of the perspective of the moisture resistance (solubility in water), resolution, and developability of the coating film after exposure although it varies depending on the resin structure.

In the present invention, the total amount of the carboxyl group-containing resin (A1) and the carboxyl group-containing resin (A2) is 60 to 80% by mass of the total amount of the carboxyl group-containing resin (A). In addition, the amount of the carboxyl group-containing resin (A3) is 40 to 20% by mass of the total amount of the carboxyl group-containing resin (A). By containing these three types of carboxyl group-containing resins in specific proportions, it is possible to suppress both plating solution contamination and plating defects while still meeting the characteristics required of solder resist, such as insulation reliability. The amount of each carboxyl group-containing resin used is the amount used when converted to solid content (the same applies below).

The total amount of the carboxyl group-containing resin (A1) and the carboxyl group-containing resin (A2) is preferably 65 to 75% by mass of the total carboxyl group-containing resin (A) in view of the perspective of gold plating resistance.

Regarding the mixing ratio of the carboxyl group-containing resins (A1) to (A3) above, the amount of the carboxyl group-containing resin (A1) should be included at a ratio of 10 to 60% by mass of the total carboxyl group-containing resin (A) from the perspective of suppressing non-adhesion of gold plating, and it is preferable to include it at a ratio of 10 to 40% by mass.

In addition, the amount of the carboxyl group-containing resin in (A2) is preferable 20 to 60% by mass, and more preferably 40 to 60% by mass of the entire carboxyl group-containing resin (A) in view of the perspective of suppressing the re-adhesion of the developing residue to the substrate.

Besides, the amount of the carboxyl group-containing resin in (A3) is preferably 40 to 20% by mass of the total carboxyl group-containing resin (A) in view of the perspective of suppressing PCT resistance and abnormal gold plating.

The amount of the carboxyl group-containing resin (A) is preferably 20 to 60% by mass based on the photosensitive resin composition. Adding 20% or more improves the coating strength. Adding 60% or less makes the viscosity appropriate, improving workability. More preferably, the amount is 25 to 50% by mass.

<(B) Photopolymerizable Monomer>

(B) photopolymerizable monomer contained in the photosensitive resin composition is a monomer with an ethylene unsaturated double bond. (B) photopolymerizable monomer can be the same as that indicated in the above-mentioned curable resin composition.

The amount of (B) photopolymerizable monomer in the photosensitive resin composition is preferably 1 to 50 parts by mass based on 100 parts by mass of the carboxyl group-containing resin in terms of solid content. More preferably the amount is 5 to 40 parts by mass.

<Photoinitiator>

The photosensitive resin composition of the present invention may contain a photoinitiator to cause the reaction of the (A) carboxyl group-containing resin and (B) photopolymerizable monomer by exposure. The photoinitiator may be the same as that used in the curable resin composition described above.

The amount of photoinitiator added is preferably 1 to 20 parts by mass based on 100 parts by mass of the carboxyl group-containing resin in terms of the solid content. When the amount is 1 part by mass or more, the light-curing properties of the photosensitive resin composition are good, and the film properties such as chemical resistance are also good. In addition, when the amount is 20 parts by mass or less, the effect of reducing outgassing is obtained, and in addition, light absorption on the surface of the cured film is good, and deep curing properties are not easily reduced. More preferably, the amount is 2 to 15 parts by mass.

In addition, in the present invention, a photoinitiator or photosensitizer may be used in combination with a photoinitiator. The photoinitiator or photosensitizer may be the same as that indicated in the above-mentioned curable resin composition.

<(C) Thermosetting Component>

The photosensitive resin composition of the present invention includes (A) a carboxyl group-containing resin, (B) a photopolymerizable monomer, and further (C) a thermosetting component. The inclusion of thermosetting components improves the barrier properties (e.g. etching resistance, etc.) of the cured film in subsequent processes, while also enabling a high level of compatibility between resolution and peeling properties. The thermosetting components (C) can be the same as those indicated as "curable resin" in the above-mentioned curable resin composition.

In addition, the photosensitive resin composition of the present invention can preferably use epoxy resins having isocyanuric rings in view of the perspective of achieving both resolution and separability, even among epoxy resins. Examples of the epoxy resins having isocyanuric rings include bifunctional epoxy isocyanurate ester compounds such as 1,3-bis(2,3-epoxypropyl)-5-(2-propenyl)-1,3,5-triazine-2,4,6(1H,3H,5H)-trione; 1,3,5-tris( 2,3-epoxypropyl)-1,3,5-triazine-2,4,6(1H,3H,5H)-trione, 1,3,5-tris(2,3-epoxy-2-methylpropyl)-1,3,5-triazine-2,4,6(1H,3H,5H)-trione, 1 , 3,5-tris(3,4-epoxybutyl)-1,3,5-triazine-2,4,6(1H,3H,5H)-trione, 1,3,5-tris(4,5-epoxypentyl)-1,3,5-triazine-2,4,6(1H,3H,5H)-trione, etc. trifunctional epoxy isocyanurate ester compounds, such as 1,3,5-tris{2-[2,2-bis(2,3-epoxypropyl)oxymethyl]butyl-oxycarbonyl}ethyl-1,3,5-triazine-2,4,6(1H,3H,5H)-trione, and tetra-functional compounds, etc., including multifunctional epoxy isocyanurate ester compounds, etc., with three-functional epoxy isocyanurate ester compounds being preferred, and 1,3,5-tris(2,3-epoxypropyl)-1,3,5-triazine-2,4,6(1H,3H,5H)-trione, 1,3,5-tris(3,4-epoxybutyl)-1,3,5-triazine-2,4,6(1H,3H,5H)-trione, or 1,3,5-tris(3,4-epoxybutyl)-1,3,5-triazine-2,4,6(1H,3H,5H)-trione, or 1,3,5-tris(3,4-epoxybutyl)-1,3,5-triazine-2,4,6(1H,3 (3,4-epoxybutyl)-1,3,5-triazine-2,4,6(1H,3H,5H)-trione, or 1,3,5-tris(4,5-epoxypentyl)-1,3,5-triazine-2,4,6(1H,3H,5H)-trione.

Examples of commercially available epoxy resins containing isocyanuric rings include TEPIC-PAS B26L, TEPIC-PAS B22, TEPIC-VL, TEPIC-UC, TEPIC-G, TEPIC-S, TEPIC-SP, and TEPIC-SS, all manufactured by Nissan Chemical Industries, Ltd. PIC-VL, TEPIC-UC, TEPIC-G, TEPIC-S, TEPIC-SP, TEPIC-SS, etc.

The amount of thermosetting component (C) to be added is preferably 0.8 to 2.5 moles of the functional group of (C) thermosetting component to react per 1.0 mole of carboxyl group contained in (A) carboxyl group-containing resin, and more preferably 1.0 to 2.0 moles.

In particular, when using epoxy resin as (C) thermosetting component, the epoxy group of the epoxy resin is 1.0 to 2.0 moles per 1.0 mole of the carboxyl group of the (A) carboxyl group-containing resin. By using more than 1 mol, it is possible to prevent the residual carboxyl groups in the cured film, and to obtain good heat resistance, alkali resistance, electrical insulation, etc. In addition, by using a composition of 2 mol or less, it is possible to prevent the residual low molecular weight cyclic (thio) ether groups in the dried coating film, and to ensure good strength of the cured film, etc.

<Thermosetting Catalyst>

The photosensitive resin composition may also contain a thermosetting catalyst to promote the curing of the thermosetting component (C) described above. The thermosetting catalysts described above for the curable resin composition may be used.

The above-mentioned thermosetting catalysts can be used alone or in combination with two or more types. In view of the perspective of storage stability of photosensitive resin compositions and heat resistance of cured films, the amount of thermosetting catalysts is preferably 0.01 to 8 parts by mass based on 100 parts by mass of (A) carboxyl group-containing resin in terms of solid content.

<(D) Inorganic Filler>

The photosensitive resin composition of the present invention can be blended with (D) inorganic filler as necessary to increase the physical strength of the cured film, etc. As inorganic fillers, known fillers can be used, and in particular, silica, talc, mica, aluminum oxide, calcium oxide, magnesium oxide, zinc oxide, calcium carbonate, magnesium carbonate, fly ash, dehydrated sludge, kaolin, clay, calcium hydroxide, aluminum hydroxide, magnesium hydroxide magnesium, hydrotalcite, aluminum silicate, magnesium silicate, calcium silicate, wollastonite, potassium titanate, magnesium sulfate, calcium sulfate, magnesium phosphate, sepiolite, zonolite, boron nitride, aluminum borate, silica balloon, glass flake , glass balloons, iron and steel slag, copper, iron, iron oxide, sendust, alnico magnets, magnetic powders such as various ferrites, cement, glass powder, Neuburg diatomite, diatomaceous earth, antimony trioxide, magnesium oxy-sulfate, hydrated aluminum, hydrated gypsum, alum and barium sulfate, etc. Other inorganic fillers may be used alone or in combination.

Among the above, silica, talc and barium sulfate are preferable. Silica can be either amorphous or crystalline, or a mixture of the two. In particular, amorphous (fused) silica is preferable.

In view of the perspective of dispersibility, etc., the inorganic filler preferably have an average particle diameter (D50) of 0.1 to 100 $\mu$m, and 0.1 to 50 $\mu$m is even more preferable. The average particle size refers to the particle size at the 50% volume accumulation point obtained using the laser diffraction particle size distribution measurement method. The average particle size of the filler refers to the value measured as described above for the filler before the photosensitive resin composition is prepared (preliminary mixing and kneading).

The amount of inorganic filler in the photosensitive resin composition is preferably 1 to 500 parts by mass based on 100 parts by mass of the carboxyl group-containing resin, and more preferably 10 to 300 parts by mass. Such amount improves the prevention of the decrease in the adhesive strength of the photosensitive resin composition and the resistance to cold and heat cycles.

The inorganic fillers mentioned above may be surface-treated to improve their dispersibility in photosensitive resin compositions. Using surface-treated inorganic fillers can help to prevent agglomeration. There are no particular restrictions on the surface treatment method, and any conventional method may be used, but it is preferable to treat the surface of the inorganic filler with a surface treatment agent that has a curable reaction group, such as a coupling agent that has a curable reaction group as an organic group.

The coupling agent can be the same as that used in the above-mentioned curable resin composition. It is preferable that the silane coupling agent is adsorbed or immobilized on the surface of the inorganic filler by reaction in advance. Here, the amount of coupling agent to be treated for 100 parts by mass of the inorganic filler is preferably 0.5 to 10 parts by mass.

<Other Components>

In addition to the above-mentioned components, the photosensitive resin composition of the present invention can also use the components indicated as "other components" in the above-mentioned curable resin composition as necessary.

The present invention's photosensitive resin composition may contain organic solvents in view of the perspective of ease of preparation and application. The organic solvents can be the same as those used in the curable resin composition described above.

The amount of organic solvent in the photosensitive resin composition can be changed as appropriate depending on the materials that make up the photosensitive resin composition, for example, it can be 30 to 300 parts by mass based on 100 parts by mass of (A) carboxyl group-containing resin in term of the solid content. The amount of organic solvent used here also includes the organic solvent contained in the varnish when using (A) carboxyl group-containing resin or other resins as a varnish.

The photosensitive resin composition of the present invention may be used in dry film form or as a liquid. When used as a liquid, it may be a single-component liquid or a two-component liquid or more.

<Dry Film>

The curable resin composition mentioned above and the photosensitive resin composition of the preset invention can also be in the form of a dry film, comprising a first film and a resin layer formed on the first film, which is made of the above-mentioned curable resin composition or photosensitive resin composition. The first film in the dry film of the present invention is one that is at least partially bonded to the resin layer when the dry film is laminated onto a substrate or other base material using heat or other means so that the side of the resin layer, which is made up of the curable resin composition or photosensitive resin composition, is in contact with the base material. The first film may be peeled off from the resin layer in the process after lamination. In particular, it is preferable that the first film is peeled off from the resin layer in the process after exposure in the present invention.

The dry film can be formed by diluting the above curable resin composition with an organic solvent to adjust to an appropriate viscosity; applying the dilution on the surface of the above support using a comma coater, a blade coater, an LIP coater, a rod coater, a squeeze coater, a reverse coater, a transfer roll coater, a gravure coater, a spray coater, a bar coater, or the like such that a uniform thickness is attained on the support; and drying the coating usually at a temperature of 50°C to 130°C for 1 to 30 minutes. The thickness of the coating film is not in particular restricted; and is in general selected as appropriate in a range of 1 to 150 $\mu$m and preferably 10 to 60 $\mu$m in the thickness after the drying.

As the first film, commonly used known film can be used with no limitation. For example, films composed of thermoplastic resins such as polyester films such as polyethylene terephthalate or polyethylene naphthalate, polyimide films, polyamide-imide films, polypropylene films, or polystyrene films can be suitably used. Of these, polyester films can be suitably used from the viewpoint of thermal resistance, mechanical strength, ease of handling, and the like. In addition, the laminate of these films can also be used as the first film.

In addition, for the purpose of improving the strength, films stretched in a uniaxial direction or a biaxial direction are preferably used as the thermoplastic resin film described above.

The thickness of the first firm is not in particular restricted and is selected as appropriate in a range of approximately 10 to 150 $\mu$m.

For the purpose of preventing dust and the like from adhere to the surface of the curable resin layer and concurrently improving the operatability and the like, a second film is preferably provided on the side of the dry film opposed to the side of the curable resin layer in contact with the first film after forming a resin layer of the above curable resin composition or the above photosensitive resin composition on the first film. The second film in the dry film of the present invention refers to the film that peels off from the resin layer before lamination when the dry film is laminated onto a substrate or other base material so that the resin layer is in contact with the base material, and then molded as a single piece by heating or other means.

For the second film that can be peeled off from the resin layer, for example, polyethylene film, polytetrafluoroethylene film, polypropylene film, and paper with a surface treatment can be used, and it is sufficient if the adhesion force between the resin layer and the second film is smaller than the adhesion force between the resin layer and the first film when the second film is peeled off.

The thickness of the second firm is not in particular restricted and is selected as appropriate in a range of approximately 10 to 50 $\mu$m.

<Process for Producing the Cured Product>

The cured product can be obtained by curing the curable resin composition or the resin layer of the dry film described above. For example, the curable resin composition is adjusted to a viscosity suitable for the coating method using the organic solvents described above, and then coated onto a substrate or other surface using a method such as the dip coating method, flow coating method, roll coating method, bar coating method, screen printing method, or curtain coating method, etc., and then evaporating and drying (temporary drying) the organic solvents contained in the composition at a temperature of 60-100°C to form a tack-free resin layer. In the case of dry film, the resin layer is formed on the substrate by laminating it onto the substrate so that the resin layer comes into contact with the substrate using a laminator, etc., and then peeling off the carrier film.

The above substrates include printed wiring boards and flexible printed wiring boards with circuits formed in advance using copper and other materials, as well as materials like paper phenol, paper epoxy, glass cloth epoxy, glass polyimide, glass cloth/non-woven fabric epoxy, glass cloth/paper epoxy, synthetic fiber epoxy, and copper-clad laminates for high-frequency circuits made from fluororesin, polyethylene, polyphenylene ether, polyphenylene oxide, cyanate, etc., and all grades (like FR-4) of copper-clad laminates, as well as other materials like metal substrates, polyimide film, polyethylene terephthalate film, polyethylene naphthalate (PEN) film, glass substrates, ceramic substrates, and wafer boards, etc.

In case of in the form of a dry film, it is preferable to laminate it onto the substrate using a vacuum laminator or similar device under pressure and heat. When using a substrate with a circuit pattern, the dry film adheres to the circuit substrate even if the surface of the circuit substrate is uneven, so there is no risk of air bubbles being trapped, and the filling of holes in the recessed parts of the substrate surface is also improved. The pressure conditions should be around 0.1 to 2.0 MPa, and the heating conditions should be between 40 and 120°C.

When the curable resin composition contains organic solvents, it is preferable to carry out volatile drying after applying the cured product resin composition to the substrate surface. Volatile drying can be carried out using a hot air circulation drying furnace, IR furnace, hot plate, convection oven, etc. (using a heat source with a steam-heated air heating system to make the hot air in the dryer undergo counter-current contact, or by blowing it onto the substrate from a nozzle).

After forming a resin layer on the substrate, the product is selectively exposed to active energy rays through a photomask with a predetermined pattern, and the unexposed areas are developed using a dilute alkaline aqueous solution (e.g., a 0.3 to 3% sodium carbonate aqueous solution) to form a pattern of cured products. In the case of dry film, after exposure, the first film is peeled off from the dry film and developed to form a cured product patterned on the substrate. In the case of dry film, if it does not impair the characteristics, the first film may be peeled off from the dry film before exposure, and the exposed resin layer may be exposed and developed.

An exposure apparatus used for the active energy ray irradiation only need to be an apparatus that includes a high-pressure mercury vapor lamp, an ultrahigh pressure mercury vapor lamp, a metal halide lamp, mercury short-arc lamp and the like and radiates an ultraviolet ray of 350 to 450 nm. Further, a direct patterning apparatus (for example, a laser direct imaging apparatus that directly draws picture images using a laser based on CAD data from a computer) can also be used. A source of laser light of the direct patterning equipment may be either a gas laser or a solid laser as long as it employs a laser light with a maximum wavelength in a range of 350 to 450 nm. The exposure amount for the picture image formation varies in film thickness and the like, and can in general be set to in the range of 10 to 1000 mJ/cm$^2$ and preferably in the range of 20 to 600 mJ/cm$^2$.

The development step is not particularly restricted; a dipping method, a shower method, a spray method, a brush method, or the like can be employed. Further, as a development liquid, an aqueous solution of alkali such as potassium hydroxide, sodium hydroxide, sodium carbonate, potassium carbonate, sodium phosphate, sodium silicate, ammonia, amines, or tetramethylammonium hydroxide can be used.

The cured product of the present invention can be obtained by heating curing (e.g., 100-220°C) after the exposure and development described above (final curing). In order to keep the average linear thermal expansion rate within the range of 70 to 100 ppm/°C, it is preferable to irradiate the cured product with active energy rays after heat curing. By irradiating the active energy rays again after heat curing, it is possible to adjust the average linear thermal expansion rate to the desired value by further curing the photopolymerizable monomers, etc., depending on the composition of the curable resin composition, and as a result, the adhesion after the marking ink has cured is also excellent.

The irradiation of active energy rays after heat curing is preferably carried out at an exposure dose of 500 to 2000 mJ/cm$^2$, depending on the composition of the curable resin composition. Equipment like high-pressure mercury lamps (3 lamps of 80 W/cm$^3$) can be used.

The cured product of the present invention is used to form solder resist or coverlay or interlayer insulating layer of electronic components like printed wiring boards. It may also be used to form solder dams on printed wiring boards. Of these, it is preferable to use it to form solder resist. With the cured product of this invention, when the cured product is formed on the printed wiring board described below, it is easy to apply marking ink to the surface, and it has excellent adhesion with the marking ink after curing, and it is also possible to form a marker with excellent visibility of letters and symbols on the surface.

In addition, the method for forming a cured product from the photosensitive resin composition of the present invention or the resin layer of the dry film can also use the same method as the method for manufacturing the cured product of this invention described above.

Besides, The cured product obtained from the photosensitive resin composition according to the present invention or the resin layer of the dry film thereof can form a film (cured coating film) consisting of a cured product with excellent adhesion, hardness, and other properties by heat curing (for example, 100 to 220°C) after exposure and development to form a pattern of the cured product on the substrate and further after active energy ray irradiation to the cured product, or by performing final finishing curing by irradiating active energy rays after heat curing or by heat curing alone.

[Printed Wiring Board]

The printed wiring board of the present invention has a cured product of the present invention, or a cured product obtained from the photosensitive resin composition of the present invention or its dry film. The process for producing the cured product is as described above.

Examples of the substrate for forming the printed wiring board can include, in addition to printed wiring boards on which a circuit is in advance formed with copper or the like and flexible printed wiring boards, all grades (FR-4 and the like) of copper clad laminates that use materials of copper clad laminates for high frequency circuit using paper phenol, paper epoxy, glass cloth epoxy, glass polyimide, glass cloth/non-woven fabric epoxy, glass cloth/paper epoxy, synthetic fiber epoxy, fluorine resin·polyethylene·polyphenylene ether, polyphenylene oxide-cyanate, or the like, other wafer boards, metal boards, polyimide films, polyethylene terephthalate films, polyethylene naphthalate (PEN) films, glass boards, ceramic boards, and wafer substrates.

In the printed wiring board of the present invention, after the cured coating film is formed on the substrate as described above, components such as electronic elements are mounted on the substrate by solder reflow processing. Solder reflow processing can be performed using conventionally known methods. Solder reflow is generally performed under conditions of 245 to 260°C for 5 to 10 seconds.

The photosensitive resin composition or dry film of the present invention is used for producing electronic components such as printed wiring boards, and is more suitable for use in forming permanent coating film. In this case, a cured product is formed using the photosensitive resin composition or dry film of the present invention by the method described above. If the photosensitive resin layer of the photosensitive resin composition or dry film of the present invention is insulating, it is preferably used to form a solder resist layer, coverlay, or interlayer insulating layer. The photosensitive resin composition of the present invention may also be used to form solder dams.

[EXAMPLES]

Next, the present invention will be explained in more detail with reference to Examples. However, the present invention is not limited to these Examples. In addition, all "part(s)" and "%" below are based on mass unless otherwise specified.

<Synthesis Example 1 (Synthesis of Carboxyl Group-Containing Resin Varnish A1-1)>

A four-necked flask equipped with a stirrer and a reflux condenser was charged with 220 parts of a cresol novolak-type epoxy resin (EPICLON N-695 manufactured by DIC CORPORATION; epoxy equivalent: 214, average number of function groups:7.6) and 214 parts of carbitol acetate were added, then dissolved by heating. Next, 0.1 parts of hydroquinone as a polymerization inhibitor and 2.0 parts of dimethylbenzylamine as a reaction catalyst were added. This mixture was heated from 95°C to 105°C, 72 parts of acrylic acid was gradually added dropwise, and the mixture was allowed to react for 16 hours. This reaction product was cooled from 80°C to 90°C, and 106 parts of tetrahydrophthalic anhydride was added and allowed to react therewith for 8 hours. After cooling, the resulting product was collected. The thus obtained carboxyl group-containing resin solution had a nonvolatile content of 65%, a solid content acid value of 85 mg KOH/g, and a weight average molecular weight of 10,000. Hereinafter, this resin solution is referred to as varnish A1-1.

<Synthesis Example 2 (Synthesis of Carboxyl Group-Containing Resin Varnish A1-2)>

A flask was charged with 200 parts of a biphenyl novolac-type epoxy resin (P-201 manufactured by Nippon Kayaku Co., Ltd.; epoxy equivalent: 200), 96.4 parts of carbitol acetate as a solvent were added, and then dissolved by heating.

Next, 0.1 parts of hydroquinone as a polymerization inhibitor and 2.0 parts of triphenylphosphine as a reaction catalyst were added to the mixture in the flask. This mixture was heated from 95°C to 105°C, 72 parts of acrylic acid was gradually added dropwise, and the mixture was allowed to react for about 16 hours until acid value was 3.0 mg KOH/g or less. This reaction product was cooled from 80°C to 90°C, and 76.1 parts of tetrahydrophthalic anhydride was added and allowed to react therewith for about 6 hours until the absorption peak of the anhydride ($1780 cm^{-1}$) disappeared. Then, 96.4 parts of aromatic solvent (Ipxol #150 manufactured by Idemitsu Petrochemical Co., Ltd.) were added to the reaction solution, and the solution was diluted before being removed. The thus obtained carboxyl group-containing resin solution had a nonvolatile content of 65%, a solid content acid value of 78 mg KOH/g, and a weight average molecular weight of 8,000. Hereinafter, this resin solution is referred to as varnish A1-2.

<Synthesis Example 3 (Synthesis of Carboxyl Group-Containing Resin Varnish A2-1)>

371 parts of bisphenol A epoxy resin having an average degree of polymerization of n = 3.3 (epoxy equivalent: 650 g/eq, softening point: 81.1°C) and 925 parts of epichlorohydrin were dissolved in 462.5 parts of dimethyl sulfoxide, and then 52.8 parts of 98.5% sodium hydroxide were added over 100 minutes while stirring at 70°C. After the addition, the reaction was carried out for 3 hours at 70°C. After the reaction was complete, 250 parts of water were added, and the reaction product was washed. After separating the oil and water, most of the dimethyl sulfoxide and excess unreacted epichlorohydrin were distilled off under reduced pressure from the oil layer, and then the reaction product, which contained residual by-product salt and dimethyl sulfoxide, was dissolved in 750 parts of methyl isobutyl ketone, and then 10 parts of 30% sodium hydroxide were added and the mixture was allowed to react at 70°C for 1 hour. After the reaction was complete, the product was washed twice with 200 parts of water. After separating the oil and water, methyl isobutyl ketone was distilled off from the oil layer to obtain an epoxy resin with an epoxy equivalent of 287 g/eq and a softening point of 64.2°C. According to calculation from the epoxy equivalent, the epoxy resin obtained was epoxidized about 3.1 of the 3.3 alcoholic phenolic hydroxyl groups in the starting material bisphenol A epoxy resin mentioned above.

310 parts of the epoxy resin obtained and 282 parts of carbitol acetate were placed in a flask, heated to 90°C, stirred, and dissolved. The resulting solution was cooled to 60°C, and then 72 parts (1 mol) of acrylic acid, 0.5 parts of methyl hydroquinone, and 2 parts of triphenylphosphine were added. The mixture was heated to 100°C and reacted for about 60 hours, and a reaction product having an acid value of 0.2 mg KOH/g was obtained. 140 parts (0.92 moles) of tetrahydrophthalic anhydride were added to the reaction product, and the mixture was heated to 90°C to obtain a carboxyl group-containing resin solution. The carboxyl group-containing resin solution obtained in this way had a nonvolatile solid content of 64.0%, a solid content acid value of 100 mg KOH/g, and a weight average molecular weight of 15,000. Hereinafter, this resin solution is referred to as varnish A2-1.

<Synthesis Example 4 (Synthesis of Carboxyl Group-Containing Resin Varnish A2-2)>

380 parts of bisphenol F epoxy resin having an average degree of polymerization of n = 6.2 (epoxy equivalent: 950 g/eq, softening point: 85°C) and 925 parts of epichlorohydrin was dissolved in 462.5 parts of dimethyl sulfoxide, and then 60.9 parts (1.5 moles) of 98.5% sodium hydroxide was added over 100 minutes while stirring at 70°C. After the addition, the reaction was carried out for a further 3 hours at 70°C. After the reaction was complete, 250 parts of water was added, and the reaction product was washed. After separating the oil and water, most of the dimethyl sulfoxide and excess unreacted epichlorohydrin were distilled off under reduced pressure from the oil layer, and the reaction product, which contained residual by-product salt and dimethyl sulfoxide, was dissolved in 750 parts of methyl isobutyl ketone, and then 10 parts of 30% sodium hydroxide were added and the mixture was reacted at 70°C for 1 hour. After the reaction was complete, the product was washed twice with 200 parts of water. After separating the oil and water, methyl isobutyl ketone was distilled off from the oil layer to obtain an epoxy resin with an epoxy equivalent of 310 g/eq and a softening point of 69°C. According to calculation from the epoxy equivalent, the epoxy resin obtained was epoxidized about 5 of the 6.2 alcoholic phenolic hydroxyl groups in the starting material bisphenol F epoxy resin mentioned above.

310 parts of the epoxy resin obtained and 282 parts of carbitol acetate were loaded into a flask, heated to 90°C and stirred to dissolve. The resulting solution was cooled to 60°C, and then 72 parts (1 mol) of acrylic acid, 0.5 parts of methyl hydroquinone, and 2 parts of triphenylphosphine were added. The mixture was heated to 100°C and react for about 60 hours, and a reaction product having an acid value of 0.2 mg KOH/g was obtained. 140 parts (0.92 moles) of tetrahydrophthalic anhydride were added to the reaction product, and the mixture was heated to 90°C to obtain a carboxyl group-containing resin solution. The carboxyl group-containing resin solution obtained in this way had a nonvolatile solid content of 65.0%, a solid content acid value of 100 mg KOH/g, and a weight average molecular weight of 15,000. Hereafter, this resin solution is referred to as Varnish A2-2.

<Synthesis Example 5 (Synthesis of Carboxyl Group-Containing Resin Varnish A3-1)>

A 2-liter separable flask equipped with a stirrer, thermometer, reflux condenser, dropping funnel, and nitrogen inlet tube was charged with 900 parts of diethylene glycol dimethyl ether as a solvent and heated to 90°C. After heating, 309.9 parts of methacrylic acid, 116.4 parts of methyl methacrylate, and 109.8 parts of lactone-modified 2-hydroxyethyl methacrylate (Plaxel FM1, manufactured by Daicel Corporation) were added together with along with 21.4 parts of bis(4-tert-butylcyclohexyl)peroxy dicarbonate (made by Nippon Oil & Fats Co., Ltd., Peroyl TPC) as a polymerization initiator were added in drops for 3 hours, and further matured for 6 hours to obtain a reaction product. The reaction was carried out in a nitrogen atmosphere.

Then, 363.9 parts of 3,4-epoxycyclohexylmethyl acrylate (Cyclomer A200, manufactured by Daicel Corporation), 3.6 parts of dimethylbenzylamine as an opening ring catalyst, and 1.80 parts of hydroquinone monomethyl ether as a polymerization inhibitor were added, and the epoxy ring-opening addition reaction was carried out by heating the mixture to 100°C and stirring it. After 16 hours, a carboxyl group-containing resin was obtained having a nonvolatile solid content of 53.8%, a solid content acid value of 108.9 mg KOH/g, and a weight average molecular weight of 25,000. Hereafter, this resin solution is referred to as Varnish A3-1.

<Synthesis Example 6 (Synthesis of Carboxyl Group-Containing Resin Varnish A3-2)>

A four-necked flask equipped with a reflux condenser, thermometer, glass tube for nitrogen replacement, and stirrer was charged with 42 parts of methacrylic acid, 43 parts of methyl methacrylate, 35 parts of styrene, 100 parts of carbitol acetate, 0.5 parts of lauryl mercaptan, and 4 parts of azobisisobutyronitrile was added, and then the polymerization reaction was promoted under a nitrogen gas flow at 75°C for 5 hours. The obtained carboxyl group-containing resin solution had a nonvolatile solid content of 50%, a solid content acid value of 120 mg KOH/g, and a weight average molecular weight of 25,000. Hereafter, this resin solution is referred to as Varnish A3-2.

<Synthesis Example 7 (Synthesis of Carboxyl Group-Containing Resin Varnish B1)>

An autoclave equipped with a thermometer, nitrogen introduction device, alkylene oxide introduction device, and stirring device was charged with 119.4 parts of novolak-type cresol resin (AICA Kogyo Co., Ltd. product: Shonol CRG 951, OH equivalent: 119.4), 1.19 parts of potassium hydroxide, and 119.4 parts of toluene were added, and then heated while stirring and the nitrogen was replaced. Next, 63.8 parts of propylene oxide were gradually added, and the reaction was carried out at 125 to 132°C and 0 to 4.8 kg/cm$^2$ for 16 hours. After that, the solution was cooled to room temperature, and 1.56 parts of 89% phosphoric acid were added and mixed with the reaction solution to neutralize the potassium hydroxide to obtain a propylene oxide reaction solution of novolak-type cresol resin having a nonvolatile solid content of 62.1% and a hydroxyl value of 182.2 g/eq. For the resin an average of 1.08 moles of alkylene oxide per phenolic hydroxyl group was added.

Next, a reactor equipped with a stirrer, thermometer and air injection pipe was charged with 293.0 parts of the obtained alkylene oxide reaction solution of the novolak-type cresol resin, 43.2 parts of acrylic acid, 11.53 g of methanesulfonic acid, 0.18 parts of methylhydroquinone and 252.9 parts of toluene, and then the mixture was reacted at 110°C for 12 hours while being stirred and with air being blown in at a rate of 10 ml/min. The water produced by the reaction was distilled off as a azeotropic mixture with toluene, and 12.6 parts of water were distilled off. The reaction solution was then cooled to room temperature, and the resulting solution was neutralized with 35.35 parts of 15% sodium hydroxide solution, and then washed with water. After that, toluene was removed by replacing it with 118.1 parts of carbitol acetate in an evaporator, and a novolak-type acrylate resin solution was obtained.

Next, a reactor equipped with a stirrer, thermometer and air injection tube was charged with 332.5 parts of the obtained novolak-type acrylate resin solution and 1.22 parts of triphenylphosphine, and then while stirring, gradually added 60.8 parts of tetrahydrophthalic anhydride, and reacted at 95 to 101°C for 6 hours. A resin solution of a carboxyl group-containing photosensitive resin obtained in this way had a nonvolatile solid content of 71%, a solid content acid value of 88 mg KOH/g, and a weight average molecular weight of 2,500. Hereafter, this resin solution is referred to as Varnish B1.

<Synthesis Example 8 (Synthesis of Carboxyl Group-Containing Resin Varnish B2)>

A flask equipped with a stirrer, a cooling tube and a thermometer was charged with 220 parts of Cresol Novolac epoxy resin (manufactured by Nippon Kayaku Co., Ltd., EOCN-104S, softening point: 92°C, epoxy equivalent: 220), 40.2 parts of of dimethylol propionic acid, and 260 parts of carbithol acetate, and then dissolved by heating at 90°C. Next, the resin solution was cooled to 60°C, 0.7 parts of triphenylphosphine were added, and the mixture was heated to 100°C. After reacting for about 32 hours, a resin solution having a nonvolatile solid content of 50% and an epoxy equivalent of 371 g/eq. was obtained.

Next, a reaction vessel equipped with a gas inlet tube, an agitator, a cooling tube, a thermometer, and a dropping funnel for continuous dropping of an aqueous solution of an alkali metal hydroxide was charged with 20 3 parts of 1,5-dihydronaphthalene with a hydroxyl group equivalent of 80 g/eq. and 1097 parts of Epikuron-840 (manufactured by DIC Corporation, epoxy equivalent: 180) of bisphenol A epoxy resin were added and dissolved at 120°C under stirring in a nitrogen atmosphere. After that, 0.65 parts of triphenylphosphine were added, and the temperature in the flask was raised to 150°C, and the reaction was allowed to proceed for about 90 minutes while maintaining the temperature at 150°C, to obtain an epoxy compound with an epoxy equivalent of 365g/eq. After that, the temperature in the flask was cooled to 70°C or below, and 2058 parts of epichlorohydrin and 1690 parts of dimethyl sulfoxide were added, and the temperature was raised to 70°C and maintained under stirring. After that, 244 parts of 48% sodium hydroxide were added over for 90 minutes, and the reaction was allowed to continue for a further 3 hours. After the reaction was complete, the majority of the excess epichlorohydrin and dimethyl sulfoxide were recovered by vacuum distillation, and the reaction products, which contained by-product salt and dimethyl sulfoxide, were dissolved in methyl isobutyl ketone and washed with water. After separating the organic solvent layer and the aqueous layer, methyl isobutyl ketone was distilled off from the organic solvent layer under reduced pressure to obtain a polyfunctional epoxy compound with an epoxy equivalent of 275 g/eq. (epoxidation rate of alcoholic hydroxyl groups: approx. 48%).

Next, a flask equipped with a stirrer, a cooling tube and a thermometer was charged with 371 parts of the resin solution prepared as described above and 137.5 parts of the polyfunctional epoxy compound were placed, and then 137 parts of carbitol acetate were added and dissolved by heating, and then 0.46 parts of methyl hydroquinone and 1.38 parts of triphenylphosphine were added, the mixture was heated to 95 to 105°C, and 72 parts of acrylic acid were added dropwise over 16 hours. The reaction product was cooled to 80 to 90°C, and 146 parts of tetrahydrophthalic anhydride were added and reacted for 8 hours. The reaction was followed by oxidation and total oxidation measurement of the reaction solution by potentiometric titration, and the endpoint was set at a reaction rate of 95% or more. The thus obtained carboxyl group-containing resin had a nonvolatile solid content of 62%, a solid acid value of 102 mg KOH/g, and a weight average molecular weight of 10,000. Hereafter, this resin solution is referred to as Varnish B2.

<Synthesis Example 9 (Synthesis of Carboxyl Group-Containing Resin Varnish B3)>

1070 parts of ortho-cresol novolac epoxy resin (manufactured by DIC Corporation, EPICLON N-695, softening point: 95°C, epoxy equivalent: 214, average functional group number: 7.6), 360 parts of acrylic acid, and 1.5 parts of hydroquinone were added to 650 parts of carbithol acetate, and then the mixture was heated and stirred at 100°C until it dissolved evenly. Next, 4.3 parts of triphenylphosphine were added, and after heating to 110°C and reacting for 2 hours, a further 1.6 parts of triphenylphosphine were added, and the temperature was raised to 120°C and the reaction continued for a further 12 hours.

525 parts of aromatic hydrocarbon (T-SOL 150, manufactured by Standard Oil Osaka Sales Office Co., Ltd.) and 608 parts of tetrahydrophthalic anhydride (4.0 moles) were added to the resulting reaction solution, and the reaction was carried out at 110°C for 4 hours. Then, 142.0g of glycidyl methacrylate was added to the resulting reaction solution and the reaction was carried out at 115°C for 4 hours. The thus obtained carboxyl group-containing resin solution had a nonvolatile solid content of 65%, a solid content acid value of 77 mg KOH/g, and a weight average molecular weight of 11,000 to 12,000. Hereafter, this resin solution is referred to as Varnish B3.

<Preparation of Curable Resin Composition>

For each of the curable resin compositions, the components in contents listed in Table 1 below were blended and dispersed and kneaded with a three-roll mill to prepare each individual curable resin composition. Note that the contents listed in the table are in units of parts by mass. Note that the amounts (values) of each component indicate the amounts of solid content (the amount of the organic solvent (i.e., carbitol acetate) listed in the table is the actual amount).

Each of components *1 to *19 in Tables 1 and 2 below are as follows.

*1: Dipentaerythritol penta and hexa acrylate, photopolymerizable monomer (DPHA, Kyoeisha Chemical Co., Ltd.)
*2: Urethane acrylate, oligomer (CN9178, Arkema (Sertomer) Inc.)
*3: Cresol novolac epoxy resin (RN-695, manufactured by DIC Corporation)
*4: Tri-epoxy resin with isocyanuric ring (TEPIC-S, Nissan Chemical Co., Ltd.)
*5: Bisphenol A epoxy resin (jER 828, manufactured by Mitsubishi Chemical Corporation)
*6: Multifunctional solid epoxy resin containing a dicyclopentadiene backbone (HP-7200, manufactured by DIC Corporation)
*7: Biphenyl aralkyl epoxy resin (YX-4000, Nippon Kayaku Co., Ltd.)
*8: Biphenyl aralkyl epoxy resin (NC3000H, Mitsubishi Chemical Corporation)
*9: $\alpha$-Aminoacetophenone photoinitiator (Omnirad 907, IGM Resins, Inc.)
*10: Acylphosphine oxide photoinitiator (Omnirad 819, manufactured by IGM Resins)
*11: o-aminoacetophenone photoinitiator (Omnirad 369, manufactured by IGM Resins)
*12: Titanocene photoinitiator (JMT-784, manufactured by Yueyang Kimoutain Sci-tech Co.)
*13: Amorphous silica (FS-3DC, manufactured by DENKA Corporation, D50 = 2.9 $\mu$m)
*14: Amorphous silica (HS-311, manufactured by NITTETSU CHEMICAL & MATERIALS CORPORATION, D50=2.2

μm)
*15: Talc (LMP-100, manufactured by Fuji Talc Industry Co.)
*16: Barium sulfate (B-100, manufactured by Sakai Chemical Industry Co.)
*17: 2,4-Diethylthioxanthone (KAYACURE DETX-S, Nippon Kayaku Co., Ltd.)
*18: 2-isopropyl thioxanthone (KAYACURE ITX, Nippon Kayaku Co., Ltd.)
*19: Melamine (D50=0.5 μm, manufactured by Nissan Chemical Co.)

<Producing Cured Product>

The curable resin compositions of the Example and Comparative Example were screen-printed onto a copper-clad laminate for printed wiring boards (FR-4, thickness 1.6 mm, size 150 x 95 mm) to form a dry coating firm of 20 μm, and then dried at 80°C for 30 minutes to form a coating firm.

Then, the coating firm was exposed in a pattern that left the coating on the entire surface, and thereafter development was carried out in 1wt% $Na_2CO_3$ solution at 30°C for 60 seconds. The optimal exposure dose was defined as the exposure dose at which the pattern of the remaining step tablet was 7 steps when the exposure was carried out using a step tablet (Kodak No. 2) via an exposure device equipped with a metal halide lamp and the development (30°C, 0.2 MPa, 30°C, 1 wt% $Na_2CO_3$ solution) was carried out for 60 seconds. After exposure and development, the samples were cured at 150°C for 30 minutes. After curing, for Examples 1 and 2 and Comparative Example 2, the surface of the coating firm was irradiated using a high-pressure mercury lamp (3 lamps of 80 $W/cm^3$, 1000 $mJ/cm^2$) to obtain the test substrate 1 formed a cured coating film thereon.

<Evaluation of Cured Product Properties>

The average linear thermal expansion coefficient and glass transition temperature (Tg) of the cured product obtained were measured as follows.

The cured product obtained as described above was cut into a test piece with 3 mm wide and 30 mm long, and the thermal expansion coefficient was measured in tensile mode using a thermomechanical analyzer (TMA/SS6000, manufactured by Seiko Instruments Inc.). The maximum load for tension was 50 N/m, the span (distance between the grips) was 10 mm, and the temperature increase rate was 10°C/min. The test piece was attached to the thermal mechanical analyzer, heated from 30°C to 200°C, left for 10 minutes. The test piece was then cooled to -30°C at a rate of -10°C/min and measured from -30°C to 250°C at a rate of 10°C/min. Each measurement value was read at 0°C and 180°C. An average linear thermal expansion coefficient ($\alpha$) was calculated using the following formula:

$$\alpha = (1/LS) \times \{L(180) - L(0)\} / (T(180) - T(0))$$

In the formula,

LS: Length (measured value) of the test piece (cured product) before measurement,
L(0): Amount of change in test piece (cured product) length at 0°C (measured value),
L(180): Amount of change in test piece (cured product) length at 180°C (measured value),
T(0):0(°C), and
T(180):180(°C).

From the TMA curve obtained, a straight line passing through the two points of 0°C and 30°C (line A) and a straight line passing through the two points of 150°C and 180°C (line B) were drawn, respectively, and the temperature at the point where lines A and B intersect (extrapolation point) was taken as the Tg of the cured product of this invention.

The measurement results are shown in Table 1 below.

Table 1

| Composition of curable resin composition | | | Ex. | | | Comp. Ex. | | |
|---|---|---|---|---|---|---|---|---|
| | | | 1 | 2 | 3 | 1 | 2 | 3 |
| Curable resin | Photocurable resin | DPHA[*1] | 20 | 20 | 10 | 11 | 20 | 15 |
| | | CN9178[*2] | - | - | 20 | - | - | - |
| | Thermosetting resin | Vanish A1-1 | 15 | 75 | - | 100 | - | 20 |
| | | Vanish A2-1 | - | - | 70 | - | - | - |
| | | Vanish A2-2 | 55 | - | - | - | - | - |
| | | Vanish A3-1 | 30 | 25 | - | - | - | - |
| | | Vanish B1 | - | - | - | - | 100 | - |
| | | Vanish B2 | - | - | - | - | - | 80 |
| | | Vanish B3 | - | - | 30 | - | - | - |
| | | RN-695[*3] | 20 | - | - | 30 | 25 | 20 |
| | | TEPIC-S[*4] | 8 | 18 | - | 15 | 8 | 8 |
| | | jER 828[*5] | - | 18 | 30 | - | - | - |
| | | HP-7200[*6] | - | - | - | - | 10 | - |
| | | YX-4000[*7] | - | - | - | - | - | 30 |
| | | NC3000H[*8] | - | - | 35 | - | - | - |
| Photoinitiator | | Omnirad 907[*9] | 10 | 10 | 4 | 17 | - | - |
| | | Omnirad 819[*10] | - | - | - | - | 10 | - |
| | | Omnirad 369[*11] | - | - | - | - | - | 10 |
| | | JMT-784[*12] | - | - | 7 | - | - | - |
| Inorganic filler | | FS-3DC[*13] | 30 | 15 | - | - | 100 | - |
| | | HS-311[*14] | - | - | 30 | - | - | 10 |
| | | LMP-100[*15] | 10 | 15 | - | 10 | - | - |
| | | B-100[*16] | 150 | 150 | 20 | 140 | - | - |
| | | Aluminum hydroxide | - | - | 40 | - | - | - |
| Colorant | | Pigment Blue 15:3 | 0.3 | 0.3 | 2 | - | 1 | 0.5 |
| | | Pigment Yellow 147 | 0.8 | 0.8 | - | - | 0.5 | 0.3 |
| | | Pigment Yellow 149 | - | - | 3 | - | - | - |
| | | Pigment Green 7 | - | - | - | 0.5 | - | - |
| Photosensitizer | | KAYACURE DETX-S[*17] | 1 | 1 | - | 1 | - | - |
| | | KAYACURE ITX[*18] | - | - | - | - | - | 1 |
| Thermosetting catalyst | | Melamine[*19] | 5 | 5 | 4 | 5 | 5 | 3 |
| Organic solvent | | Carbitol acetate | 20 | 20 | 20 | 20 | 20 | 20 |
| Curing condition | | Additional exposure after heat curing | Yes | Yes | No | No | Yes | No |
| Average linear thermal expansion coefficient when the temperature is changed from 0-180°C (ppm/°C) | | | 78 | 72 | 86 | 75 | 33 | >100 |
| Grass transition temperature of cured product (°C) | | | 110 | 120 | 80 | 108 | 155 | 70 |

<Marking Evaluation>

(1) Printability

The test substrate obtained as described above were printed using a marking ink (PMR-6000 W30, manufactured by Taiyo Ink Mfg. Co., Ltd.) in a rectangle 10 × 20 mm in size, with a thickness 20 $\mu$m of the cured coating firm after curing. The markers were formed by drying the printed substrate at 80°C for 30 minutes. The printability of the markers was evaluated by the following evaluation criteria, after visually checking the printed condition of the markers.

○: No bleeding or smearing
×: Bleeding or smearing

The evaluation results are shown in Table 2 below.

(2) Adhesion

The surface of the cured coating film on the test substrate obtained as described above was printed using a marking ink (PMR-6000 W30, manufactured by Taiyo Ink Mfg. Co., Ltd.) in a rectangle 10 × 20 mm in size, with a thickness of 20 μm of the cured coating firm after curing. After drying the printed substrate at 80°C for 30 minutes, the printed area was exposed using a pattern that left characters and symbols of approximately 10 to 20 μm, and this was developed in 1 wt% $Na_2CO_3$ at 30°C for 60 seconds. The optimal exposure dose was defined as the dose at which the pattern of the step tablet remaining after development (30°C, 0.2 MPa, 30°C, 1 wt% $Na_2CO_3$ solution) for 60 seconds was 8 steps when exposed using a step tablet (Kodak No. 2) via an exposure device equipped with a metal halide lamp after drying. The coating firm was then washed in water at 10°C for 60 seconds, and cured at 180°C for 45 minutes to form a marker.

Next, adhesive tape was attached to the marker area and a peeling test was conducted. The evaluation criteria were as follows.

◎: No peeling
○: Some peeling is observed in some areas
×: Peeling is observed throughout

The evaluation results are shown in Table 2 below.

(3) Visibility of marker

The characters and symbols on the marker of the evaluation samples used in the adhesion evaluation in (2) above were checked visually to see if they were legible. The evaluation criteria for the visibility of the marker were as follows.

◎: All characters and symbols are legible
○: Some characters and symbols are difficult to read
×: Characters and symbols are difficult to read throughout

The evaluation results are shown in Table 2 below.

Table 2

| | Ex. | | | Comp. Ex. | | |
|---|---|---|---|---|---|---|
| | 1 | 2 | 3 | 1 | 2 | 3 |
| Additional exposure after heat curing | Yse | Yse | No | No | Yse | No |
| Average linear thermal expansion coefficient of cured product 0-180°C (ppm/°C) | 78 | 72 | 86 | 75 | 33 | >100 |
| Grass transition temperature of cured product (°C) | 110 | 120 | 80 | 108 | 155 | 70 |
| Printability of marking ink | ○ | ○ | ○ | Δ | Δ | × |
| Adhesion to marking ink | ◎ | ○ | Δ | × | × | × |
| Visibility of maker | ◎ | ○ | Δ | × | × | × |

As can be seen from Table 2, the cured products (Examples 1 to 3) with an average linear thermal expansion coefficient of 70 to 100 ppm/°C when the temperature changes from 0°C to 180°C have good printability with marking ink, excellent adhesion with marking ink, and can form markers with excellent legibility of letters and symbols.

In contrast, when the average linear thermal expansion coefficient is less than 70 ppm/°C or exceeds 100 ppm/°C (Comparison Examples 2 and 3), it can be seen that the printability of the marking ink is not good and the adhesion to the marking ink is also insufficient.

Even if the average linear thermal expansion coefficient is within the range of 70 to 100 ppm/°C when the temperature changes from 0°C to 180°C, it can be seen that the cured product formed using a curable resin composition that does not contain amorphous silica has poor printability of marking ink and insufficient adhesion to marking ink, just like the other comparative examples.

<Preparation of Photosensitive Resin Composition>

The photosensitive resin compositions listed in the table below were obtained by mixing the components listed in Table 3 below using a three-roll mill at room temperature. The figures in the table indicate mass percentages. The amounts of each carboxyl group-containing resin in the table indicate the amounts of the varnish obtained as described above. The components *1 to *19 in the table below are as described above.

<Evaluation of Photosensitive Resin Composition>

(1) Evaluation of re-adhesion of developing residue

This evaluation was conducted as an item for evaluating the suppression of plating defects. Specifically, the photosensitive resin compositions obtained as described above were applied to a comb-shaped L/S = 100μm/100μm patterned substrate with a 0.5m × 0.5m × 1.6mm pad area that had been polished with a buff, and a coating firm was formed on both sides using screen printing so that the thickness of the coating firm after development was 20μm.
Next, the substrate having the coating firm was then held for 10 minutes, and then dried in a hot air circulation drying furnace at 80°C for 40 minutes. After leaving the substrate having the dried coating firm at room temperature for 30 minutes, 100 sheets were developed using a developing machine (Solder Resist Developing Machine (150L tank) made by Tokyo Kako Kiki Co., Ltd.) containing 1% $Na_2CO_3$ aqueous solution (liquid temperature 30°C), and the number of re-adhered developing residues was checked visually. The evaluation criteria were as follows.

○: There were no reattachments
Δ: There were 1 to 9 reattachments
×: There were 10 or more reattachments

The evaluation results are shown in Table 3 below.

(2) PCB Test (Pressure Cooker Bias Test)

This test was conducted to evaluate the characteristics (insulation reliability) required of solder resist. Specifically, each photosensitive resin composition was applied to a comb-shaped L/S = 100μm/100μm patterned substrate with a pad area and a coating firm was formed on both sides using screen printing so that the thickness of the coating firm after development was 20μm.
Next, the substrate having the coating firm was then dried in a hot air circulation drying furnace at 80°C for 40 minutes. After leaving the substrate having the dried coating firm at room temperature for 30 minutes, it was exposed to an exposure dose of 400mJ/cm$^2$ and developed for 60 seconds using a developer (Tokyo Kako Kiki Co., Ltd. Solder Resist Developer (150L tank)) containing 1% $Na_2CO_3$ aqueous solution (liquid temperature 30°C). This was followed by a post-curing treatment at 150°C for 60 minutes to cure the coating film, and a substrate having the cured coating film (hereafter referred to as the "test substrate") was produced.
For the insulation reliability of the test substrate, the insulation resistance was measured continuously inside the test chamber using an insulation degradation evaluation tester (IMV Corporation MIG-8600B) at 121°C, humidity of 97% and an applied voltage of 30V, and then the time when the resistance value was dropped to $10^6$ Ω or less insulation (i.e., insulation reliability was lost) was measured. The evaluation criteria were as follows.

◎: 150 hours or more
○: 100 to 149 hours
Δ: 50 to 99 hours
×: 49 hours or less

The evaluation results are shown in Table 3 below.

(3) Plating evaluation

The following evaluation was carried out as an item for evaluating the suppression of plating defects. Specifically, the test boards described above were degreased by immersion in an acidic degreasing solution (20% aqueous solution of Metex L-5B, manufactured by McDermid Japan Co., Ltd.) at 30°C for 3 minutes, and then rinsed by immersion in running water for 3 minutes.
Next, the test substrate was immersed in 14.3 wt% aqueous solution of ammonium persulfate at room temperature for 3 minutes to perform a soft etch, and then rinsed by immersing in running water for 3 minutes. After immersing the test substrate in 10 vol% aqueous solution of sulfuric acid at room temperature for 1 minute, it was rinsed by immersing in running water for 30 seconds to 1 minute.

The test substrate was then immersed in a 30°C catalyst solution (10% aqueous solution of Metal Plate Activator 350, manufactured by Mertex Co., Ltd.) for 7 minutes to apply the catalyst, and then rinsed under running water for 3 minutes.

The test substrate given a catalyst were immersed in a nickel plating solution (20 vol% aqueous solution of Melplate Ni-865M, pH 4.6, manufactured by Meltex Co., Ltd.) at 85°C for 30 minutes for 30 minutes to perform electroless nickel plating. After immersing the test substrate in 10% sulfuric acid solution at room temperature for 1 minute, it was rinsed by immersing it in running water for 30 seconds to 1 minute.

The test substrate was then immersed in a gold plating solution (manufactured by Meltex Co., Ltd., Aurolectroless UP 15 vol% and potassium cyanide 3 vol% aqueous solution, pH 6) at 95° C for 30 minutes immersed in a solution of $5\mu m$ Ni and $0.05\mu m$ Au, and then immersed in running water for 3 minutes to rinse, and then immersed in hot water at 60°C for 3 minutes to wash. After rinsing thoroughly, the water was well drained, dried, and the test board with electroless gold plating was obtained.

The pad areas of the test substrate that had undergone electroless gold plating as described above was visually inspected to check whether the plating had adhered, and the presence or absence of plating was evaluated according to the following criteria.

∘: No plating was observed
Δ: Plating was observed in one location
×: Plating was observed in many locations

The evaluation results are shown in Table 3 below.

In addition, the following evaluation was carried out as an item to assess the suppression of plating solution contamination. Specifically, the plated surface of the pad area of the test substrate was visually checked for abnormalities, and the presence or absence of plating surface abnormalities was evaluated according to the following criteria.

∘: No abnormalities
Δ: One abnormality
×: Many abnormalities

The evaluation results are shown in Table 3 below.

Table 3

| Composition of photocurable resin composition | | Ex. | | | | | Comp. Ex. | | | | |
|---|---|---|---|---|---|---|---|---|---|---|---|
| | | 4 | 5 | 6 | 7 | 8 | 4 | 5 | 6 | 7 | 8 |
| (A1)Carboxylic group-containing resin | Vanish A1-1 | 25 | 25 | - | 25 | 25 | 154 | 76 | - | 76 | - |
| | Vanish A1-2 | - | - | 25 | - | - | - | - | - | - | 25 |
| (A2)Carboxylic group-containing resin | Vanish A2-1 | - | 92 | - | - | - | - | - | - | - | - |
| | Vanish A2-2 | 92 | - | 92 | 92 | 92 | - | 76 | 76 | - | 46 |
| (A3)Carboxylic group-containing resin | Vanish A3-1 | 64 | 64 | 64 | - | - | - | - | 114 | - | 128 |
| | Vanish A3-2 | - | - | - | 56 | 56 | - | - | - | 100 | - |
| (B)Photopolymerizable monomer | DPHA*1 | 20 | 20 | 20 | 20 | 20 | 20 | 20 | 20 | 20 | 20 |
| (C)Thermosetting component | RN-695*3 | 20 | 20 | 20 | 20 | 20 | 20 | 20 | 20 | 20 | 20 |
| | TEPIC-S*4 | 8 | 8 | 8 | 8 | - | 8 | 8 | 8 | 8 | 8 |
| (E)Photoinitiator | Omnirad 907*9 | 10 | 10 | 10 | 10 | 10 | 10 | 10 | 10 | 10 | 10 |
| | KAYACURE DETX-S*17 | 1 | 1 | 1 | 1 | 1 | 1 | 1 | 1 | 1 | 1 |

(continued)

| Composition of photocurable resin composition | | Ex. | | | | | Comp. Ex. | | | | |
|---|---|---|---|---|---|---|---|---|---|---|---|
| | | 4 | 5 | 6 | 7 | 8 | 4 | 5 | 6 | 7 | 8 |
| (D) Inorganic filler | FS-3DC*13 | 30 | 30 | 30 | 30 | 30 | 30 | 30 | 30 | 30 | 30 |
| | LMP-100*15 | 10 | 10 | 10 | 10 | 10 | 10 | 10 | 10 | 10 | 10 |
| | B-100*16 | 150 | 150 | 150 | 150 | 150 | 150 | 150 | 150 | 150 | 150 |
| Colorant | Pigment Blue 15:3 | 0.3 | 0.3 | 0.3 | 0.3 | 0.3 | 0.3 | 0.3 | 0.3 | 0.3 | 0.3 |
| | Pigment Yellow 147 | 0.8 | 0.8 | 0.8 | 0.8 | 0.8 | 0.8 | 0.8 | 0.8 | 0.8 | 0.8 |
| Thermosetting catalyst | Melamine*19 | 5 | 5 | 5 | 5 | 5 | 5 | 5 | 5 | 5 | 5 |
| Organic solvent | Carbitol acetate | 20 | 20 | 20 | 20 | 20 | 20 | 20 | 20 | 20 | 20 |
| Evaluation | Evaluation of re-adhesion of developing residue | ○ | ○ | ○ | ○ | ○ | ○ | ○ | Δ | × | Δ |
| | PCBT | ◎ | ◎ | ◎ | ○ | ○ | × | Δ | ○ | Δ | ○ |
| | Presence or absence of plating | ○ | ○ | ○ | ○ | ○ | ○ | ○ | Δ | × | × |
| | Presence or absence plating surface abnormalities | ○ | ○ | ○ | ○ | ○ | Δ | × | × | Δ | Δ |

As can be seen from Table 3, the photosensitive resin compositions (Examples 4 to 8) that combine three specific types of carboxyl group-containing resin in specific proportions can suppress the contamination of plating solutions and the occurrence of plating defects while still meeting the characteristics required of solder resist, such as insulation reliability.

On the other hand, in the photosensitive resin composition (Comparison Example 4) that uses only a carboxyl group-containing resin with a novolak structure, although the occurrence of plating liquid contamination and plating defects can be suppressed, the properties required of solder resist, such as insulation reliability, are insufficient.

Besides, in the photosensitive resin composition that uses two types of carboxyl group-containing resins, one with a novolak structure and the other with a bisphenol structure (Comparison Example 5), and in the photosensitive resin composition that uses two types of carboxyl group-containing resins, one with a bisphenol structure photoresist composition (Comparison Example 6) that uses two types of resin, one containing carboxyl groups with a bisphenol structure and the other containing carboxyl groups with an unsaturated base acid copolymer structure, it is thought that abnormalities occur on the plating surface and contamination of the plating solution occurs.

In addition, in the photosensitive resin composition (Comparison Example 7) that uses a combination of two types of carboxyl group-containing resin, one of which is a carboxyl group-containing resin with a novolak structure and the other of which is a carboxyl group-containing resin of the unsaturated base acid copolymer type, it can be seen that defects such as non-plating occur due to the influence of the residue in the developing solution.

Furthermore, even when three specific types of carboxyl group-containing resin are combined, if the ratio of each component is outside the specified range, the photosensitive resin composition (Comparison Example 8) will not meet the required characteristics for solder resist, such as insulation reliability, and defects such as incomplete plating due to the influence of residue in the developing solution will occur, as well as abnormalities occurring on the plated surface and contamination of the plating solution.

**Claims**

1.  A cured product of a curable resin composition comprising a curable resin and an inorganic filler **characterized in that** the inorganic filler comprises an amorphous silica, and the cured product has an average linear thermal expansion coefficient of 70 to 100 ppm/°C when the temperature is changed from 0 to 180°C.

2.  The cured product according to claim 1, wherein the cured product has a glass transition point (Tg) in the range of 100 to 120°C.

3.  The cured product according to claim 1, wherein the cured product has an average linear thermal expansion coefficient of 70 to 85 ppm/°C when the temperature is changed from 0 to 180°C.

4.  The cured product according to claim 1, wherein the curable resin comprises a thermosetting resin and a photo-curable resin.

5.  The cured product according to claim 1, wherein the amorphous silica is contained in 2 to 30% by mass with respect to the entire curable resin composition in terms of solid content.

6.  A photosensitive resin composition comprising (A) carboxyl group-containing resin, (B) photopolymerizable monomer and (C) thermosetting component **characterized in that**

    (A) carboxyl group-containing resin comprises:

    (A1) carboxyl group-containing resin having a novolac skeleton,
    (A2) carboxyl group-containing resin having a bisphenol skeleton and
    (A3) carboxyl group-containing resin of an unsaturated basic acid copolymerization type,
    the total amount of (A1) carboxyl group-containing resin and (A2) carboxyl group-containing resin is 60 to 80% by mass with respect to the total of (A) carboxyl group-containing resin, and
    the amount of (A3) carboxyl group-containing resin is 40 to 20% by mass with respect to the total amount of (A) carboxyl group-containing resin.

7.  The photosensitive resin composition according to claim 6, wherein the (A3) carboxyl group-containing resin is a reaction product of an unsaturated basic acid copolymerization resin and an unsaturated compound containing an alicyclic epoxy group.

8.  The photosensitive resin composition according to claim 6, wherein the amount of (A1) carboxyl group-containing resin is 10 to 60% by mass with respect to the total amount of (A) carboxyl group-containing resin.

9.  The photosensitive resin composition according to claim 6, wherein the amount of (A2) carboxyl group-containing resin is 20 to 50% by mass with respect to the total amount of (A) carboxyl group-containing resin.

10. The photosensitive resin composition according to claim 6, wherein the thermosetting component comprises an epoxy resin having an isocyanuric ring.

11. The photosensitive resin composition according to claim 6, further comprises a (D) inorganic filler.

12. The photosensitive resin composition according to claim 11, wherein the (D) inorganic filler comprises a fused silica.

13. A dry film comprising a resin layer obtained by applying and drying a photosensitive resin composition according to claim 6 on a first film.

14. A cured product obtained by curing the photosensitive resin composition according to claim 6 or the resin layer of the dry film according to claim 13.

15. The cured product according to claim 1 or 14, used for a solder resist.

16. A printed wiring board comprising a substrate and the cured product according to claim 1 or 14 on the substrate.

# INTERNATIONAL SEARCH REPORT

International application No.

**PCT/JP2023/012395**

## A. CLASSIFICATION OF SUBJECT MATTER

***C08L 101/00***(2006.01)i; ***C08L 101/08***(2006.01)i; ***C08F 2/44***(2006.01)i; ***C08F 2/46***(2006.01)i; ***C08L 63/00***(2006.01)i; ***G03F 7/004***(2006.01)i; ***G03F 7/027***(2006.01)i; ***C08K 3/36***(2006.01)i; ***H05K 3/28***(2006.01)i

FI: C08L101/00; C08K3/36; C08L101/08; C08L63/00; C08F2/44 A; C08F2/46; G03F7/004 512; G03F7/004 501; G03F7/027 515; H05K3/28 D; H05K3/28 F

According to International Patent Classification (IPC) or to both national classification and IPC

## B. FIELDS SEARCHED

Minimum documentation searched (classification system followed by classification symbols)

C08L101/00; C08L101/08; C08F2/44; C08F2/46; C08L63/00; G03F7/004; G03F7/027; C08K3/36; H05K3/28

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| X | WO 2014/200112 A1 (DOW CORNING TORAY CO., LTD.) 18 December 2014 (2014-12-18) claims 1-15, p. 10, lines 21-24, examples 5, 8 | 1, 3, 5, 16 |
| A | | 2, 4, 6-15 |
| X | JP 2009-275110 A (NITTO DENKO CORPORATION) 26 November 2009 (2009-11-26) claims 1-5, paragraph [0024], examples 1-7 | 1–3, 5, 16 |
| A | | 4, 6-15 |
| Y | JP 2017-529551 A (TAIYO INK (SUZHOU) CO., LTD.) 05 October 2017 (2017-10-05) claims 1-4, paragraphs [0006], [0016], [0029], [0038], [0066], [0079], examples 9, 11 | 6-16 |
| A | | 1–5 |
| Y | WO 03/032089 A1 (TAIYO INK MFG. CO., LTD.) 17 April 2003 (2003-04-17) claims 1-10, example 4, comparative example 2 | 6-16 |
| A | | 1–5 |

☑ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **13 June 2023** | **20 June 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2023/012395**

### C.    DOCUMENTS CONSIDERED TO BE RELEVANT

| Category* | Citation of document, with indication, where appropriate, of the relevant passages | Relevant to claim No. |
|---|---|---|
| A | WO 2017/168699 A1 (HITACHI CHEMICAL COMPANY, LTD.) 05 October 2017 (2017-10-05)<br>    paragraph [0151] | 1-16 |
| A | WO 2014/175196 A1 (TAIYO HOLDINGS CO., LTD.) 30 October 2014 (2014-10-30)<br>    entire text | 1-16 |

Form PCT/ISA/210 (second sheet) (January 2015)

## INTERNATIONAL SEARCH REPORT

International application No.

**PCT/JP2023/012395**

**Box No. III     Observations where unity of invention is lacking (Continuation of item 3 of first sheet)**

This International Searching Authority found multiple inventions in this international application, as follows:

(Invention 1) Claims 1-5 and the portions of the inventions in claims 15-16 depending from claim 1

Document 1 discloses a cured product made of a curable resin composition containing a curable resin and an inorganic filler, the cured product being characterized in that the inorganic filler contains amorphous silica, and the average coefficient of linear expansion of the cured product when the temperature changes from 0°C to 180°C is 70-100 ppm/°C (claims 1-15, p. 10, lines 21-24, examples 5, 8). Claim 1 lacks novelty in the light of document 1 and thus does not have special technical features. However, claim 2 depending from claim 1 has the special technical feature of "the cured product according to claim 1, wherein the glass transition point (Tg) is within a range from 100 to 120°C". Therefore, claims 1-2 are classified as invention 1.

Furthermore, claims 3-5 and the portions of the inventions in claims 15-16 that depend from claim 1 are dependent claims of claim 1 and are inventively linked with claim 1, and thus are classified as invention 1.

(Invention 2) Claims 6-14 and the portions of the inventions in claims 15-16 that depend from claim 14

Claims 6-14 and the portions of the inventions in claims 15-16 that depend from claim 14 share, with claim 1 classified as invention 1, the feature of "a resin composition containing a curable component". However, this feature does not make a contribution over the prior art, which is so clear that it is beyond the need for prior art search, and thus cannot be said to be a special technical feature. Furthermore, there are no other identical or corresponding special technical features between claim 1, and claims 6-14 and the portions of the inventions in claims 15-16 that depend from claim 14.

Additionally, claims 6-14 and the portions of the inventions in claims 15-16 that depend from claim 14 do not depend from claim 1. Moreover, claims 6-14 and the portions of the inventions in claims 15-16 that depend from claim 14 are not substantially identical to or similarly closely related to any of the claims classified as invention 1.

Therefore, claims 6-14 and the portions of the inventions in claims 15-16 that depend from claim 14 cannot be classified as invention 1.

Claims 6-14 and the portions of the inventions in claims 15-16 that depend from claim 14 are classified as invention 2 as a result of having the special technical feature of "a photosensitive resin composition comprising (A) a carboxyl group-containing resin, (B) a photopolymerizable monomer, and (C) a thermosetting component, the photosensitive resin composition being characterized in that: (A) the carboxyl group-containing resin includes (A1) a carboxyl group-containing resin having a novolac skeleton, (A2) a carboxyl group-containing resin having a bisphenol skeleton, and (A3) an unsaturated base acid copolymer carboxyl group-containing resin; the total content of the (A1) carboxyl group-containing resin and the (A2) carboxyl group-containing resin is 60-80% by mass relative to the (A) carboxyl group-containing resin as a whole; and the content of the (A3) carboxyl group-containing resin is 40-20% by mass relative to the (A) carboxyl group-containing resin".

Form PCT/ISA/210 (continuation of first sheet) (January 2015)

# EP 4 502 077 A1

<table>
<tr><td><strong>INTERNATIONAL SEARCH REPORT</strong></td><td>International application No.<br><strong>PCT/JP2023/012395</strong></td></tr>
</table>

**Box No. III    Observations where unity of invention is lacking (Continuation of item 3 of first sheet)**

1. ☑ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
    ☐ The additional search fees were accompanied by the applicant's protest and, where applicable, the payment of a protest fee.
    ☐ The additional search fees were accompanied by the applicant's protest but the applicable protest fee was not paid within the time limit specified in the invitation.
    ☑ No protest accompanied the payment of additional search fees.

Form PCT/ISA/210 (continuation of first sheet) (January 2015)

32

| International application No. |
| --- |
| **PCT/JP2023/012395** |

| Patent document cited in search report | | | Publication date (day/month/year) | Patent family member(s) | | | Publication date (day/month/year) |
| --- | --- | --- | --- | --- | --- | --- | --- |
| WO | 2014/200112 | A1 | 18 December 2014 | TW | 201504355 | A | |
| JP | 2009-275110 | A | 26 November 2009 | (Family: none) | | | |
| JP | 2017-529551 | A | 05 October 2017 | WO | 2016/015398 | A1 | |
| | | | | CN | 105467753 | A | |
| | | | | KR | 10-2017-0039617 | A | |
| WO | 03/032089 | A1 | 17 April 2003 | (Family: none) | | | |
| WO | 2017/168699 | A1 | 05 October 2017 | (Family: none) | | | |
| WO | 2014/175196 | A1 | 30 October 2014 | CN | 105075409 | A | |
| | | | | KR | 10-2016-0005028 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2022060840 A
- JP 2022060828 A
- JP H10142793 A
- JP 2018169537 A
- JP 2017529551 A
- WO 2003032089 A
- JP 2004359639 A
- JP 2005097141 A
- JP 2005220097 A
- JP 2006160634 A
- JP 2008094770 A
- JP 2008509967 W
- JP 2009040762 W
- JP 2011080036 A